# EUROPEAN PATENT APPLICATION

(11) **EP 4 797 266 A1**
(43) Date of publication of application: **26.08.2026**
(21) Application number: 26158836.2
(22) Date of filing: 16.02.2026
(51) Int. Cl.: G11C 7/10, G11C 16/26, G11C 16/32

(54) **NON-VOLATILE MEMORY DEVICE, STORAGE DEVICE, AND METHOD OF OPERATING THE STORAGE DEVICE**

(30) Priority: 24.02.2025 KR 20250023599
(71) Applicant: Samsung Electronics Co., Ltd., Suwon-si, Gyeonggi-do 16677 (KR)
(72) Inventor: PARK, Taehyeon, Suwon-si (KR); KIM, Sang-Lok, Suwon-si (KR); YOON, Chiweon, Suwon-si (KR); JO, Youngmin, Suwon-si (KR)
(74) Representative: Marks & Clerk LLP

(57) **Abstract**

Provided are non-volatile memory devices, storage devices, and methods of operating the storage devices. The non-volatile memory device includes a memory interface circuit including a data pin configured to output a data signal, a command address pin separated from the data pin and configured to receive a first data output packet, and a first pin configured to receive a toggle signal corresponding to the first data output packet, a first page buffer configured to output first data in response to the first data output packet, and a first register configured to provide the first data to the memory interface circuit through a first path based on receiving a first clock signal generated based on the toggle signal, and provide the first data to the memory interface circuit through a second path different from the first path in response to receiving a second clock signal different from the first clock signal.

## Description

### BACKGROUND

Non-volatile memory devices are memory devices that do not lose stored data even when power is cut off. Anon-volatile memory device may include a page buffer, an array of memory cells, a row decoder, and control logic circuitry to store data or read stored data.

The page buffer may sense data stored in a selected memory cell through a bit line, latch the sensed data, load it into an external register, and output the data.

For example, to reduce the time between receiving a read enable signal from a storage controller and outputting data and clock signals, the page buffer circuit may preload latched data into a register.

### SUMMARY

Some implementations provide non-volatile memory devices, storage devices, and methods of operating storage devices that improve speed performance for data output.

Some implementations provide a non-volatile memory device, a storage device, and a method of operating the storage device, which improve both the speed and reliability of a data output operation by preventing conflicts in the loading operation and the preloading operation of a page buffer circuit.

According to some implementations disclosed, non-volatile memory device includes a memory interface circuit including a data pin configured to output a data signal, a command address pin separated from the data pin and configured to receive a first data output packet, and a first pin configured to receive a toggle signal corresponding to the first data output packet, a first page buffer configured to output first data in response to the first data output packet, and a first register configured to provide the first data to the memory interface circuit through a first path in response to receiving a first clock signal generated based on the toggle signal, and provide the first data to the memory interface circuit through a second path different from the first path in response to receiving a second clock signal different from the first clock signal.

According to some implementations disclosed, storage device includes a non-volatile memory device including a memory interface circuit including a data pin configured to output a data signal and a command address pin separated from the data pin and configured to receive a first data output packet and a second data output packet, a first page buffer configured to output first data in response to the first data output packet, and a second page buffer configured to output second data in response to the second data output packet and A storage controller configured to provide the first data output packet and a first select chip enable command corresponding to the first data output packet to the non-volatile memory device through the command address pin, and provide the second data output packet between the first select chip enable command and a select chip terminate command corresponding to the first select chip enable command.

According to some implementations disclosed, method of operating a storage device includes a step of providing a first data output packet to a first page buffer of a first plane through a command address pin of a non-volatile memory device, a step of performing a preloading operation for the first page buffer based on the first data output packet, a step of outputting first data stored in the first page buffer through a data pin different from the command address pin to perform a first data output operation, based on the first select chip enable command, and a step of providing a second data output packet to a second page buffer of a second plane different from the first plane to the non-volatile memory device through the command address pin, during the first data output operation.

According to other implementations disclosed, non-volatile memory device data pin configured to data signal, a command address pin, separated from the data pin and configured to receive a first data output packet and a second data output packet in sequence, a first pin configured to receive a first toggle signal corresponding to the first data output packet and a second toggle signal corresponding to the second data output packet, a first page buffer configured to output first data in response to the first data output packet, a second page buffer configured to output second data in response to the second data output packet, a first register configured to receive the first data and output the first data based on a clock signal, a second register configured to receive the second data and provide the first data to the data pin based on a clock signal, a demultiplexer configured to provide a first portion of a first clock signal generated based on the first toggle signal to the first register and provide a second portion of the first clock signal to the second register.

### BRIEF DESCRIPTION OF THE DRAWINGS

FIG. 1 is a block diagram illustrating a memory system according to some implementations
FIG. 2 is a block diagram illustrating a storage device according to some implementations.
FIG. 3 is a block diagram illustrating a storage controller according to some implementations.
FIG. 4 is a diagram illustrating a CA packet transmitted via a command address signal according to some implementations.
FIG. 5 is a diagram illustrating a header and body included in a CA packet according to some implementations.
FIG. 6 is a block diagram illustrating a non-volatile memory device according to some implementations.
FIG. 7 is a drawing for explaining a three-dimensional structure of a memory cell array according to some implementations.
FIG. 8 is a circuit diagram illustrating a page buffer according to some implementations.
FIG. 9 is a diagram illustrating a non-volatile memory device including a plurality of mats according to some implementations.
FIG. 10 is a timing diagram illustrating a method of operating a storage device according to some implementations.
FIG. 11 is a block diagram illustrating a non-volatile memory device according to some implementations.
FIG. 12 is a diagram illustrating a non-volatile memory device including a plurality of mats according to some implementations.
FIG. 13 is a timing diagram illustrating a method of operating a storage device according to some implementations.
FIG. 14 is a block diagram illustrating a non-volatile memory device according to some implementations.
FIG. 15 is a is a flowchart illustrating a method of operating a storage device according to some implementations.
FIG. 16 is a block diagram illustrating an SSD system to which a storage device is applied according to some implementations.
FIG. 17 is a block diagram illustrating a data center to which a storage device according to some implementations is applied.

### DETAILED DESCRIPTION

Hereinafter, various implementations of the present disclosure will be described in detail with reference to the attached drawings so that a person having ordinary skill in the art to which the present disclosure pertains may easily implement the disclosure. The present disclosure may be embodied in many different forms and is not limited to the implementations described herein.

In order to clearly explain the present disclosure, parts irrelevant to the description are omitted, and identical or similar reference numerals are given to identical or similar components throughout the specification.

Additionally, throughout the specification, whenever a part is said to "include" a component, this does not mean that it excludes other components, but rather that it may include other components, unless otherwise specifically stated.

Additionally, a specific number set forth in a claim, even if explicitly recited in the claim, should not be construed as meaning that there is limitation to the specific number in the claim where such recitation does not exist. For example, subsequent dependent claims may include the phrases "at least one" and "one or more" to aid understanding. However, the use of this construction should not be understood as a limitation described by the indefinite article 'one' for the sake of one example.

Moreover, when a convention such as 'at least one of A, B, or C' is used, such a phrase will be well understood by a person skilled in the art (i.e., 'a system comprising at least one of A, B, or C' includes, but is not limited to, A alone, B alone, C alone, A and B, A and C, B and C, and/or A, B, and C together). Or, words and/or phrases in the detailed description or claims or drawings having two or more separate alternative terms should be considered as possibly including one, or either, or both terms. For example, the phrase 'A or B' should be understood to include the possibilities of 'A', or 'B', or 'A and B'.

The terms "module," "unit," "part," and the like, as used in this document, are terms intended to refer to a component that performs at least one function or operation, and such a component may be implemented as hardware or software, or as a combination of hardware and software.

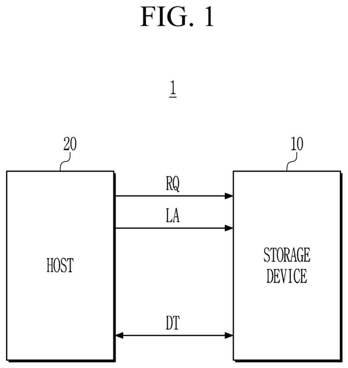

FIG. 1 is a block diagram illustrating a memory system according to some implementations.

Referring to FIG. 1, a storage system 1 may include a host device 20 and a storage device 10. According to some implementations, the storage system 1 may be provided as one of computing systems, such as an Ultra Mobile PC (UMPC), a workstation, a net-book, a PDA (Personal Digital Assistants), a portable computer, a web tablet, a wireless phone, a mobile phone, a smart phone, an e-book, a Portable Multimedia Player (PMP), a portable game console, a navigation device, a black box, a digital camera, a DMB (Digital Multimedia Broadcasting) player, a digital audio recorder, a digital audio player, a digital picture recorder, a digital picture player, a digital video recorder, a digital video player, a server, and a data center.

The host device 20 may provide an operation request RQ and a logical address LA to the storage device 10 and transmit and receive data DT with the storage device 10. The operation request RQ may include an input/output request, such as a write request for data DT and a read request for data DT, and a setup request for a storage device 10.

The host device 20 may provide input/output requests in various input/output patterns. For example, the host device 20 may provide a read request to the storage device 10 with a logical address LA in an individual random read pattern, a write request to the storage device 10 with a logical address LA in a sequential write pattern, and a write request and a read request to the storage device 10 with a logical address LA in a read after write pattern for the same data DT. Additionally, the host device 20 may provide a read request to the storage device 10 in a sequential read pattern with consecutive logical addresses LA. The above setup request may include requests for creation and modification of a namespace, and status reporting of a storage device 10, and the technical idea of the present disclosure is not limited thereto.

A logical address LA may be an address from a logical perspective managed from the perspective of a host device 20 and may be referred to as a Logical Block Address (LBA). For example, the size of data DT defined by one logical address LA may be, but is not limited to, 512B or 4KB. Additionally, the host device 20 may provide a namespace ID along with a logical address LA to the storage device 10.

The host device 20 may exchange data, etc., with the storage device 10 based on at least one of various interface protocols, such as the PCI-E (Peripheral Component Interconnect Express) protocol, the NVMe (Non-Volatile Memory Express) protocol, the PCI protocol, the USB (Universal Serial Bus) protocol, the MMC (Multi-Media Card) protocol, the ATA (Advanced Technology Attachment) protocol, the Serial-ATA protocol, the Parallel-ATA protocol, the SCSI (Small Computer Small Interface) protocol, the ESDI (Enhanced Small Disk Interface) protocol, the IDE (Integrated Drive Electronics) protocol, the MIPI (Mobile Industry Processor Interface) protocol, the UFS (Universal Flash Storage) protocol, etc.

The storage device 10 may receive an operation request RQ and a logical address LA from the host device 20 and transmit and receive data DT with the host device 20. According to some implementations, the storage device 10 may include a non-volatile memory device. As an example, the non-volatile memory device may be a NAND Flash Memory. The non-volatile memory device may include a plurality of memory blocks that store data DT. According to some implementations, the storage device 10 may operate based on the NVMe protocol and support the plurality of namespaces. NVMe is a register-level interface that communicates between a storage device 10, such as a solid state drive (hereinafter referred to as SSD), and the software of a host device 20. It is based on a physical/transport layer, such as PCI-E or CXL, and may be an interface optimized for SSD.

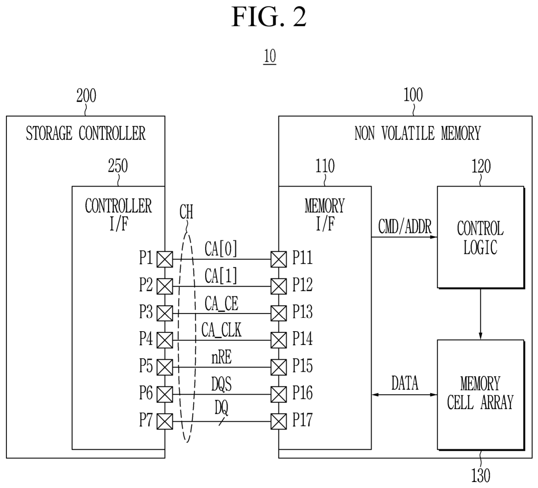

FIG. 2 is a block diagram illustrating a storage device according to some implementations.

Referring to FIG. 2, the storage device 10 may include a non-volatile memory device 100 and a storage controller 200. A non-volatile memory device 100 and a storage controller 200 may communicate with each other based on a channel CH.

The storage controller 200 may control the overall operation of the storage device 10. The storage controller 200 may transmit and receive a command CMD, an address ADDR, or data DT with a non-volatile memory device 100 according to the Separate Command Address (SCA) protocol.

The storage controller 200 may include a plurality of pins and a controller interface circuit 250. As an example, the plurality of pins may comprise first to seventh pins P1 to P7, although the number of pins may vary. The controller interface circuit 250 may transmit a command address signal CA, a chip enable signal CA_CE, a command address clock signal CA_CLK, a read enable signal nRE, a data strobe signal DQS, and a data signal DQ through first to seventh pins P1 to P7 that are separated from each other and are different from each other. The controller interface circuit 250 may transmit a data signal DQ through a plurality of seventh pins P7, as well as receive a data signal DQ from a non-volatile memory device 100. Similarly, according to some implementations, the first and second pins P1 to P2 through which a command address signal CA is input/output may be command address pins, and the plurality of seventh pins P7 through which a data signal DQ is input/output may be data pins.

A non-volatile memory device 100 may include a plurality of pins, a memory interface circuit 110, a control logic circuit 120, and a memory cell array 130. As an example, the plurality of pins may comprise first to seventh pins P11 to P17, although the number of pins may vary. Each of the first to seventh pins P11 to P17 may correspond to each of the first to seventh pins P1 to P7 of the storage controller 200. Accordingly, the memory interface circuit 110 may receive a command address signal CA, a chip enable signal CA_CE, a command address clock signal CA_CLK, a read enable signal nRE, a data strobe signal DQS, and a data signal DQ through first to seventh pins P11 to P17 that are separated from each other and are different from each other. The memory interface circuit 110 may receive a data signal DQ through a plurality of seventh pins P17, as well as transmit the data signal DQ to the storage controller 200.

According to some implementations, the first and second pins P11 to P12 to which a command address signal CA is input/output may be command address pins, and the non-volatile memory device 100 may obtain a command CMD and/or an address ADDR based on the command address signal CA. Commands CMD and addresses ADDR may be provided in the form of command address packets (CA packets). A plurality of seventh pins P17 through which data signals DQ are input/output may be data pins, and the data signals DQ may correspond to data DT programmed or read from a non-volatile memory device 100.

Each of the command address signal CA and the data signal DQ may be input/output between the storage controller 200 and the non-volatile memory device 100 through different pins. According to some implementations, while the non-volatile memory device 100 performs an input/output operation of a data signal DQ, the storage controller 200 may provide a command CMD and/or an address ADDR to the non-volatile memory device 100 based on a command address signal CA. For example, while the non-volatile memory device 100 outputs a data signal DQ, the storage controller 200 may provide a command address signal CA for data output to the non-volatile memory device 100.

According to some implementations, the memory interface circuit 110 may include an on-die termination circuit. The on-die termination circuit may perform an on-die termination (ODT) operation of setting termination resistors for a plurality of seventh pins P17, which are data pins, based on CA packets received from the first and second pins P11 to P12, and connecting the termination resistors to the plurality of seventh pins P17. The above-described on-die termination circuit may perform various ODT operations, including a self-termination operation and a non-target termination (NTO) operation, based on a command.

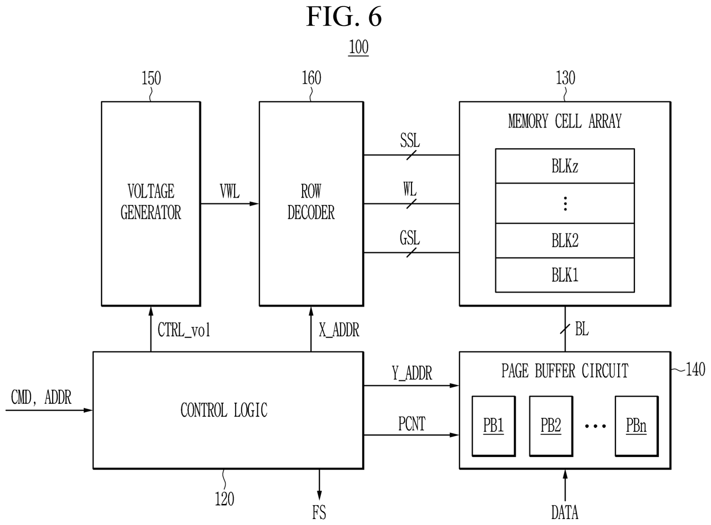

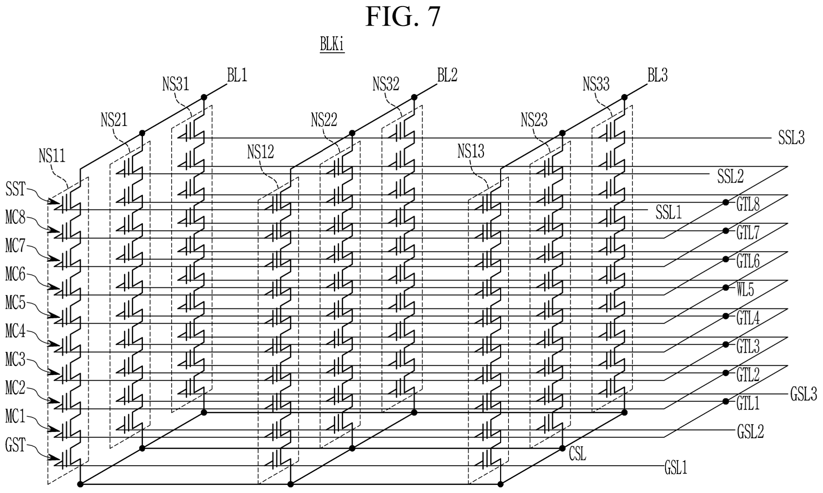

The control logic circuit 120 may control various operations within the non-volatile memory device 100. The control logic circuit 120 may output various control signals in response to a command CMD and/or an address ADDR based on a command address signal CA input from the first and second pins P11 to P12. The control logic circuit 120 may control operations for the memory cell array 130, including program operations, read operations, and erase operations for data DT, based on control signals. A detailed description for the control logic circuit 120 and the memory cell array 130 is provided later in the description of FIGS. 6 and 7.

The chip enable signal CA_CE may be provided to the non-volatile memory device 100 via the third pin P3, P13. The chip enable signal CA_CE may be a signal to select a non-volatile memory device to which a command CMD and address ADDR will be provided via the command/address line. For example, the chip enable signal CA_CE may be maintained at a logic high level and transitioned to a logic low level when a non-volatile memory device is selected, and a non-volatile memory device receiving the chip enable signal CA_CE at a logic low level may receive a command CMD and an address ADDR from a command address signal CA.

The command address clock signal CA_CLK may remain in a static state (e.g., logic high level or logic low level) and toggle between logic high level and logic low level during a specific period. For example, the command address clock signal CA_CLK may be toggled during the period in which the command address signal CA is transmitted.

The memory interface circuit 110 may provide a command address signal CA based on the toggle timing of the command address clock signal CA_CLK, and obtain a command CMD and an address ADDR from the command address signal CA. According to the implementations, the command CMD may include a data output command, a data input command, a select chip enable command, a select chip terminate command, a select chip pause command, an NTO enable command, and an NTO disable command.

In data output operation for the data signal DQ of the non-volatile memory device 100, the memory interface circuit 110 may receive a read enable signal nRE, which is a toggle signal, through the fifth pin P5, P15 before outputting the data signal DQ. The memory interface circuit 110 may generate a data strobe signal DQS that toggles based on the toggling of the read enable signal nRE. For example, the memory interface circuit 110 may generate a data strobe signal DQS that starts toggling after a predetermined delay based on the toggling start time of the read enable signal nRE, and the page buffer circuit of the non-volatile memory device 100 may perform a preloading operation to reduce the predetermined delay. The memory interface circuit 110 may output a data signal DQ for data DT based on the toggle timing of the data strobe signal DQS. Accordingly, the data signal DQ may be transmitted to the storage controller 200 aligned with the toggle timing of the data strobe signal DQS.

In data input operation for the data signal DQ of a non-volatile memory device 100, the controller interface circuit 250 may generate a toggling data strobe signal DQS. For example, the data strobe signal DQS may remain in a fixed state (e.g., high level or low level) and then start toggling before the data signal DQ is transmitted. The controller interface circuit 250 may transmit a data signal DQ for data DT to a non-volatile memory device 100 based on the toggle timing of a data strobe signal DQS. For example, the data signal DQ may be transmitted aligned with the edge timing of the data strobe signal DQS.

In FIG. 2, only the connection relationship between the storage controller 200 and one non-volatile memory device 100 is illustrated, but this disclosure is not limited thereto, and the description of the non-volatile memory device 100 in FIG. 2 may be applied to a plurality of non-volatile memory devices connected to the same channel CH.

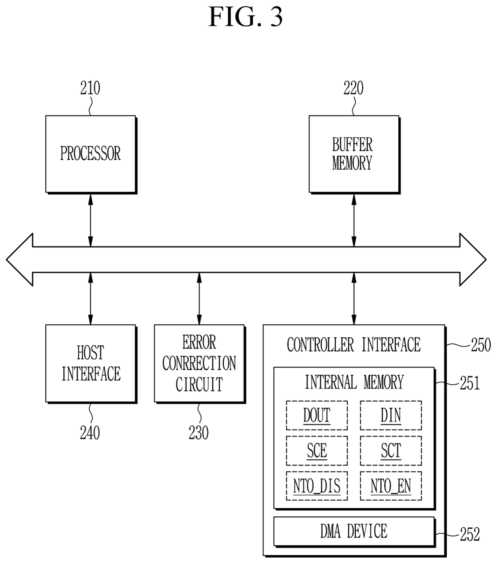

FIG. 3 is a block diagram illustrating a storage controller according to some implementations.

Referring to FIGS. 1 to 3, the storage controller 200 may control the overall operation of the storage device 10.

The storage controller 200 may execute firmware when power is supplied to the storage device 10. The firmware may include a host interface layer that controls communication with the host device 20, a flash translation layer that provides an interface between the host device 20 and the non-volatile memory device 100 so that the non-volatile memory device 100 is used efficiently, and a memory interface layer that controls communication with the non-volatile memory device 100. According to some implementations, the flash translation layer may perform an address mapping operation, a garbage collection operation, a wear leveling operation, a read reclaim operation, etc., as a memory management module to convert a logical address of a host device 20 into a physical address of a non-volatile memory device 100.

The storage controller 200 may control the non-volatile memory device 100 to perform a data input/output operation, a program operation, a read operation, or an erase operation according to an operation request RQ of the host device 20. In the present disclosure, a data input operation means an operation in which a data signal is input into a non-volatile memory device through a channel and latched as data in a page buffer, and a data output operation means an operation in which data latched in a page buffer is output as a data signal through a channel.

The storage controller 200 may provide a data input command DIN, an address, and data to the non-volatile memory device 100 during a data input operation and may provide a program command and an address to the non-volatile memory device 100 during a program operation. The storage controller 200 may provide a data output command DOUT and an address to the non-volatile memory device 100 during a data output operation and may provide a read command and an address to the non-volatile memory device 100 during a read operation. The storage controller 200 may provide an erase command and address to the non-volatile memory device 100 during an erase operation.

The storage controller 200 may include a processor 210, a buffer memory 220, an error correction circuit 230, a host interface circuit 240, and a controller interface circuit 250.

The processor 210 may control the overall operation of the storage controller 200. The processor 210 may generate commands according to an operation request RQ of the host device 20. For example, the processor 210 may generate a data output command DOUT in response to a read request from the host device 20 and may generate a data input command DIN in response to a write request from the host device 20.

According to some implementations, the data output command DOUT may be a command based on a write request of a random read pattern of the host device or a command based on a write request of a sequential read pattern of the host device. According to some implementations, the data output command DOUT may be a command based on a read request of a random write pattern of the host device or a command based on a read request of a sequential write pattern of the host device.

The processor 210 may generate an NTO enable command NTO_EN to enable an NTO operation of an on-die termination circuit included in a non-volatile memory device 100 and may generate an NTO disable command NTO_DIS to disable the NTO operation of the on die termination circuit.

The processor 210 may generate a select chip enable command SCE, a select chip terminate command SCT, a select chip pause command, etc. related to data input/output operations of the non-volatile memory device 100.

A select chip enable command SCE is a command for selecting a non-volatile memory device 100 that performs an input/output operation of a data signal among a plurality of non-volatile memory devices connected to a channel CH, and a non-volatile memory device 100 that receives the select chip enable command SCE may perform a self-termination operation as a target memory device and input/output a data signal. The select chip terminate command SCT is a command that terminates the non-volatile memory device selected by the select chip enable command SCE from inputting and outputting data signals, and a non-volatile memory device that receives the select chip terminate command SCT may terminate inputting and outputting data signals without performing a self-termination operation.

The processor 210 may control data input/output operations for the non-volatile memory device 100 based on a sequence of a data output command DOUT, a data input command DIN, a select chip enable command SCE, a select chip terminate command SCT, etc. For example, the processor 210 may control a data output operation for a non-volatile memory device 100 by controlling the storage controller 200 to sequentially output a data output command DOUT, a select chip enable command SCE, and a select chip terminate command SCT.

According to some implementations, when the storage controller 200 sequentially provides a data output command DOUT to the non-volatile memory device 100, the processor 210 may control the storage controller 200 to sequentially output the data output command DOUT, the select chip enable command SCE, the data output command DOUT, the select chip terminate command SCT, the select chip enable command SCE, and the select chip terminate command SCT. According to some implementations, the processing speed for an operation request RQ of the storage device 10 may be adjusted through the command queue of the storage controller 200, and the operation speed performance of the storage device 10 may be improved.

The processor 210 may provide the generated commands to the controller interface circuit 250. The processor 210 may control the controller interface circuit 250 to provide commands to the non-volatile memory device 100.

Buffer memory 220 may be used as cache memory or operating memory of the storage controller 200.

According to some implementations, the buffer memory 220 may temporarily store data DT provided from the host device 20 or temporarily store data DT read from the non-volatile memory device 100. According to the implementations, the buffer memory 220 may be random access memory, such as a dynamic random access memory (DRAM) or a static random access memory (SRAM). In some implementations, the buffer memory 220 may be located inside the storage controller 200 or may be located outside the storage controller 200.

According to some implementations, the error correction circuit 230 may perform an encoding operation to generate parity data for data DT received from the host device 20. The encoded data may be provided to a non-volatile memory device 100 via a controller interface circuit 250. An error correction circuit 230 may perform a decoding operation on data read from a non-volatile memory device 100. An error correction circuit 230 may correct error bits included in data read from a non-volatile memory device 100 by performing a decoding operation. The error correction circuit 230 may provide decoded data to the host device 20 through the host interface circuit 240.

The host interface circuit 240 may communicate with the host device 20. The host interface circuit 240 may receive data DT from the host device 20 or provide data DT to the host device 20.

The controller interface circuit 250 may communicate with the non-volatile memory device 100. The controller interface circuit 250 may provide data to the non-volatile memory device 100 or receive data from the non-volatile memory device 100.

According to some implementations, the controller interface circuit 250 may include internal memory 251 and a Direct Memory Access (DMA) device 252.

The internal memory 251 may store commands generated by the processor 210. Commands stored in the internal memory 251 under the control of the processor 210 may be provided to the non-volatile memory device 100. According to the implementations, the internal memory 251 may be random access memory, such as DRAM or SRAM. The DMA device 252 may transmit and receive data from a non-volatile memory device 100.

Although it is illustrated in FIG. 3 that commands generated by the processor 210 are stored as a command queue in the internal memory 251 of the controller interface circuit 250, this disclosure is not limited thereto, and according to some implementations, commands generated by the processor 210 may be stored as a command queue in the buffer memory 220.

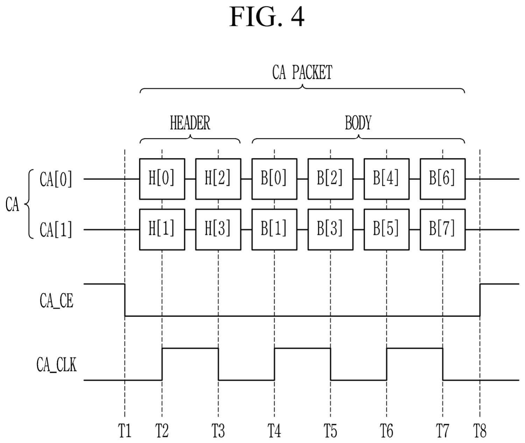

FIG. 4 is a diagram illustrating a CA packet transmitted via a command address signal according to some implementations.

Referring to FIGS. 2 and 4, the storage controller 200 and the non-volatile memory device 100 may transmit and receive a command CMD, an address ADDR, or data DT according to the SCA protocol. The SCA protocol is a protocol in which a command CMD and an address ADDR are transmitted via a command address signal CA, and data DT to be stored in a non-volatile memory device 100 or data DT read from a non-volatile memory device 100 are input/output via a data signal DQ.

According to some implementations, one command or one address transmitted to a non-volatile memory device 100 may be transmitted via a command address signal CA in the form of a CA packet. A CA packet may contain a header and a body. The header HEADER may be data indicating the type of CA packet. According to some implementations, the header may include data indicating that (e.g., indicating whether) the type of CA packet is a command or an address. A header HEADER may include a zeroth header H[0], a first header H[1], a second header H[2], and a third header H[3]. According to the implementations, the BODY may be data containing additional information related to the HEADER. In some implementations, the BODY may include a zeroth body B[0], a first body B[1], a second body B[2], a third body B[3], a fourth body B[4], a fifth body B[5], a sixth body B[6], and a seventh body B[7].

According to some implementations, the storage controller 200 may provide a CA packet to the non-volatile memory device 100 through a zeroth command address signal CA[0] and a first command address signal CA[1] when there are two command address lines. While the CA packet is provided to the non-volatile memory device 100, the level of the chip enable signal CA_CE may transition from a logic high level to a logic low level.

In some implementations, the command address clock signal CA_CLK may be toggled while the CA packet is provided to the non-volatile memory device 100. According to some implementations, the non-volatile memory device 100 may receive a zeroth header H[0] and a first header H[1] in response to a rising edge of the command address clock signal CA_CLK, and may receive a second header H[2] and a third header H[3] in response to a falling edge of the command address clock signal CA_CLK. Likewise, the non-volatile memory device 100 may receive the zeroth to seventh bodies B[0] to B[7] transmitted from the storage controller 200 in response to the rising edges and falling edges of the command address clock signal CA_CLK.

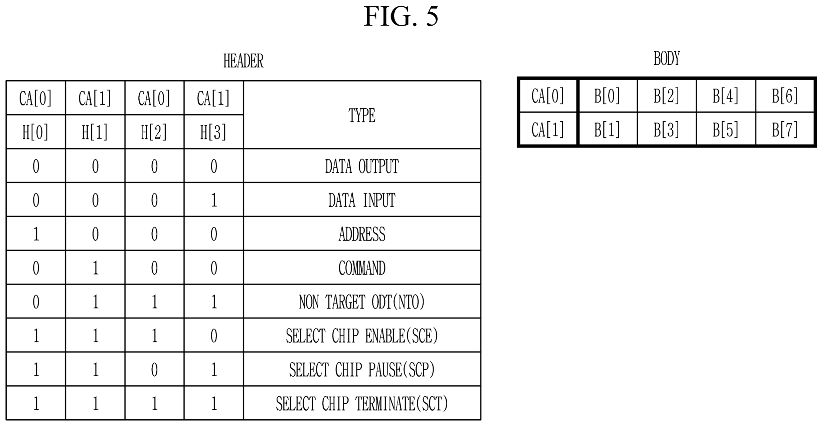

FIG. 5 is a diagram illustrating a header and body included in a CA packet according to some implementations.

Referring to FIG. 5, a CA packet transmitted via a command address signal CA may include a header HEADER and a body BODY. The header HEADER may include the zeroth to third headers H[0] to H[3]. The zeroth header H[0] and the second header H[2] may be transmitted to the non-volatile memory device 100 via the zeroth command address signal CA[0]. The first header H[1] and the third header H[3] may be transmitted to the non-volatile memory device 100 via the first command address signal CA[1].

According to some implementations, a CA packet including bit values of the zeroth to third headers H[0] to H[3] corresponding to "0000" may correspond to a data output packet. According to some implementations, a data output packet may be a packet that the storage controller 200 transmits to the non-volatile memory device 100. The zeroth to seventh bodies B[0] to B[7] of the data output packet may include an address for a non-volatile memory device 100 via a command address signal CA from the storage controller 200. According to some implementations, a data output packet corresponds to a data output command as a command CMD and may be used interchangeably as a 'data output command' in the present disclosure.

According to some implementations, a CA packet including bit values of the zeroth to third headers H[0] to H[3] corresponding to "0001" may correspond to a data input packet. According to some implementations, a data input packet may be a packet that the storage controller 200 transmits to the non-volatile memory device 100. The zeroth to seventh bodies B[0] to B[7] of the data input packet may include an address for a non-volatile memory device 100 via a command address signal CA from the storage controller 200. According to some implementations, a data input packet may correspond to a data input command as a command CMD.

According to some implementations, a CA packet including bit values of the zeroth to third headers H[0] to H[3] corresponding to "1000" may correspond to an address packet. The zeroth to seventh bodies B[0] to B[7] of the address packet may include an address ADDR provided to a non-volatile memory device 100.

According to some implementations, a CA packet including bit values of the zeroth to third headers H[0] to H[3] corresponding to "0100" may correspond to a command packet. The zeroth to seventh bodies B[0] to B[7] of the command packet may include data indicating the type of command. According to some implementations, the zeroth to seventh bodies B[0] to B[7] of the command packet may include data indicating that the command packet is a program command, a read command, an erase command, or a set feature command.

According to some implementations, a CA packet including bit values of the zeroth to third headers H[0] to H[3] corresponding to "0111" may correspond to an NTO command packet NTO. An NTO command packet NTO may be a packet that enables or disables the NTO operation of an on-die termination circuit included in a non-volatile memory device 100. According to some implementations, the zeroth to seventh bodies B[0] to B[7] of the NTO command packet NTO may include information about a non-volatile memory device to which the NTO command packet NTO is to be transmitted and information for enabling or disabling an ODT operation of an on die termination circuit.

According to some implementations, a CA packet including bit values of the zeroth to third headers H[0] to H[3] corresponding to "1110" may correspond to a select chip enable command SCE. The select chip enable command SCE may be a command to select a non-volatile memory device that inputs and outputs data signals. The zeroth to seventh bodies B[0] to B[7] of the select chip enable command SCE may include information about a non-volatile memory device to which the select chip enable command SCE is to be transmitted.

According to some implementations, a CA packet including bit values of the zeroth to third headers H[0] to H[3] corresponding to "1101" may correspond to a select chip pause command SCP. The zeroth to seventh bodies B[0] to B[7] of the select chip pause command SCP may include information about a non-volatile memory device to which the select chip pause command SCP is to be transmitted.

In some implementations, a CA packet including bit values of the zeroth to third headers H[0] to H[3] corresponding to "1111" may correspond to a select chip terminate command SCT. A select chip terminate command SCT may be a packet that terminates the input/output of a data signal. The zeroth to seventh bodies B[0] to B[7] of the select chip terminate command SCT may include information about a non-volatile memory device to which the select chip terminate command SCT is to be transmitted.

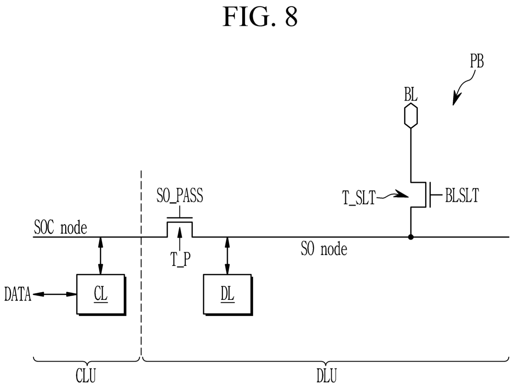

FIG. 6 is a block diagram illustrating a non-volatile memory device according to some implementations. FIG. 7 is a drawing for explaining a three-dimensional structure of a memory cell array according to some implementations. FIG. 8 is a circuit diagram illustrating a page buffer according to some implementations.

Referring to FIGS. 6 to 8, a non-volatile memory device 100 may include a control logic circuit 120, a memory cell array 130, a page buffer circuit 140, a voltage generator 150, and a row decoder 160. The non-volatile memory device 100 may further include the memory interface circuit 110 of FIG. 2, and may also further include column logic, a pre-decoder, a temperature sensor, a command decoder, an address decoder, etc.

The control logic circuit 120 may control various operations within the non-volatile memory device 100. The control logic circuit 120 may receive a command CMD and/or an address ADDR including a data output command, a data input command, a read command, or a program command from the first and second pins P11 to P12 of FIG. 2, and output various control signals in response to the command CMD and/or the address ADDR. For example, the control logic circuit 120 may output a voltage control signal CTRL_vol, a row address X-ADDR, a column address Y-ADDR, and a flag signal FS.

According to some implementations, the control logic circuit 120 may output a flag signal FS in response to receiving the data output command DOUT of FIG. 3. According to some implementations, the output flag signal FS may be provided to the memory interface circuit 110 of FIG. 2. According to some implementations, the memory interface circuit 110 may generate an internal clock signal based on the flag signal FS.

The memory cell array 130 may include a plurality of memory blocks (BLK1 to BLKz, z is a positive integer), and each of the plurality of memory blocks BLK1 to BLKz may include a plurality of memory cells. The memory cell array 130 may be connected to a page buffer circuit 140 through bit lines BL and may be connected to a row decoder 160 through word lines WL, string select lines SSL, and ground select lines GSL.

According to some implementations, the memory cell array 130 may include a three-dimensional memory cell array. The three-dimensional memory cell array may include a plurality of NAND strings. Each NAND string may include memory cells each connected to word lines stacked vertically on the substrate. According to some implementations, the memory cell array 130 may include a two-dimensional memory cell array, and the two-dimensional memory cell array may include a plurality of NAND strings arranged along the row and column directions.

Referring to FIG. 7 together, each of the plurality of memory blocks BLK1 to BLKz may be expressed as an equivalent circuit as illustrated. The memory block BLKi illustrated in FIG. 7 represents a three-dimensional memory block formed in a three-dimensional structure on a substrate. For example, a plurality of memory NAND strings included in a memory block BLKi may be formed in a direction perpendicular to the substrate.

A memory block BLKi may include a plurality of memory NAND strings NS11 to NS33 connected between a plurality of bit lines BL1, BL2, BL3 and a common source line CSL. Each of the plurality of memory NAND strings NS11 to NS33 may include a string select transistor SST, a plurality of memory cells (MC1, MC2, ..., MC8), and a ground select transistor GST. In FIG. 7, each of the plurality of memory NAND strings NS11 to NS33 is illustrated as including eight memory cells (MC1, MC2, ..., MC8), but is not necessarily limited thereto.

The string select transistors SST may be connected to corresponding string select lines SSL1, SSL2, SSL3. A plurality of memory cells (MC1, MC2, ..., MC8) may be respectively connected to corresponding gate lines (GTL1, GTL2, ..., GTL8). Gate lines (GTL1, GTL2, ..., GTL8) may correspond to word lines, and some of the gate lines (GTL1, GTL2, ..., GTL8) may correspond to dummy word lines. The ground select transistor GST may be connected to the corresponding ground select line GSL1, GSL2, GSL3. The string select transistor SST may be connected to the corresponding bit lines BL1, BL2, BL3, and the ground select transistor GST may be connected to the common source line CSL. Each of the bit lines BL1, BL2, BL3 may be connected to at least one of the page buffers (PB1 to PNn, n is a positive integer greater than or equal to 3) of the page buffer circuit 140 of FIG. 6.

Word lines of the same height (e.g., WL1) may be commonly connected, and ground select lines GSL1, GSL2, GSL3 and string select lines SSL1, SSL2, SSL3 may be separated, respectively. In FIG. 7, a memory block BLK is illustrated as being connected to eight gate lines (GTL1, GTL2, ..., GTL8) and three bit lines BL1, BL2, BL3, but is not necessarily limited thereto.

The page buffer circuit 140 may include a plurality of page buffers PB1 to PBn, and the plurality of page buffers PB1 to PBn may be respectively connected to memory cells through a plurality of bit lines BL. The page buffer circuit 140 may select at least one bit line among a plurality of bit lines BL in response to a column address Y-ADDR.

Each of the plurality of page buffers PB1 to PBn may operate as a write driver or a sense amplifier depending on the operating mode. For example, during program operation, the plurality of page buffers PB1 to PBn may apply bit line voltages corresponding to data DT to be programmed to selected bit lines. During a read operation, the plurality of page buffers PB1 to PBn may sense data DT stored in a memory cell by detecting the current or voltage of a selected bit line.

Using FIG. 8 as an example, a page buffer PB may include a cache latch unit CLU and a data latch unit DLU. The page buffer PB of FIG. 8 may correspond to one of the plurality of page buffers PB1 to PBn.

The cache latch unit CLU may include a cache latch CL. For example, a cache latch CL may store data DATA to be written to a memory cell. Additionally, the cache latch CL may store data DATA transferred from the data latch DL. A cache latch CL may be connected to a cache latch node SOC. A cache latch CL may input/output data DATA through a cache latch node SOC, and although one cache latch CL is depicted as being placed in a cache latch unit CLU in the drawing, it may include two or more cache latches CL. For example, when a non-volatile memory device 100 receives a data output command DOUT from the storage controller 200 of FIGS. 2 and 3, the cache latch CL may output latched data DATA through the cache latch node SOC.

The data latch unit DLU may include a pass transistor T_P, a data latch DL, and a bit line select transistor T_SLT. The pass transistor T_P may be turned on or off depending on the pass signal SO_PASS. The cache latch node SOC may be connected to the sensing node SO through a pass transistor T_P. When the pass transistor T_P is turned on, data DATA may be transferred between the cache latch CL and the data latch DL. For example, when a non-volatile memory device 100 receives a data input command DIN from the storage controller 200 of FIGS. 2 and 3, data DATA latched in a cache latch CL may be provided to a data latch DL through a cache latch node SOC and a pass transistor T_P.

According to some implementations, a data latch DL is connected to a sensing node SO and may store data DATA transmitted from a cache latch CL. Additionally, the data latch DL may store data DATA read from a memory cell and transfer the data DATA to the cache latch CL. Although the drawing shows one data latch DL being placed in the data latch unit DLU, it may include two or more data latches DL.

A sensing node SO may be precharged during a read or program operation of a non-volatile memory device 100. The sensing node SO may be connected to a bit line BL through a bit line select transistor T_SLT. For example, a bit line select transistor T_SLT may be connected between a bit line BL and a sensing node SO. The bit line select transistor T_SLT may be turned on or off depending on the bit line select signal BLSLT. In some implementations, the bit line select transistor T_SLT may be, but is not limited to, an NMOS transistor.

According to some implementations, data DT may be input/output in the form of a data signal DQ through a page buffer circuit 140 and a data pin of a memory interface circuit. For example, the page buffer circuit 140 may act as a kind of driver in a data output operation to provide data DT stored in a cache latch CL to a memory interface circuit, and the memory interface circuit may output a data signal DQ through a data pin.

The voltage generator 150 may generate various types of voltages for performing program, read, and erase operations based on a voltage control signal CTRL_vol. For example, the voltage generator 150 may generate a program voltage, a read voltage, a program verify voltage, an erase voltage, etc., or a bit line voltage, etc., as a word line voltage VWL.

A row decoder 160 may select one of a plurality of word lines WL and one of a plurality of string select lines SSL in response to a row address X-ADDR. For example, during a program operation, the row decoder 160 may apply a program voltage and a program verification voltage to a selected word line, and during a read operation, it may apply a read voltage to a selected word line.

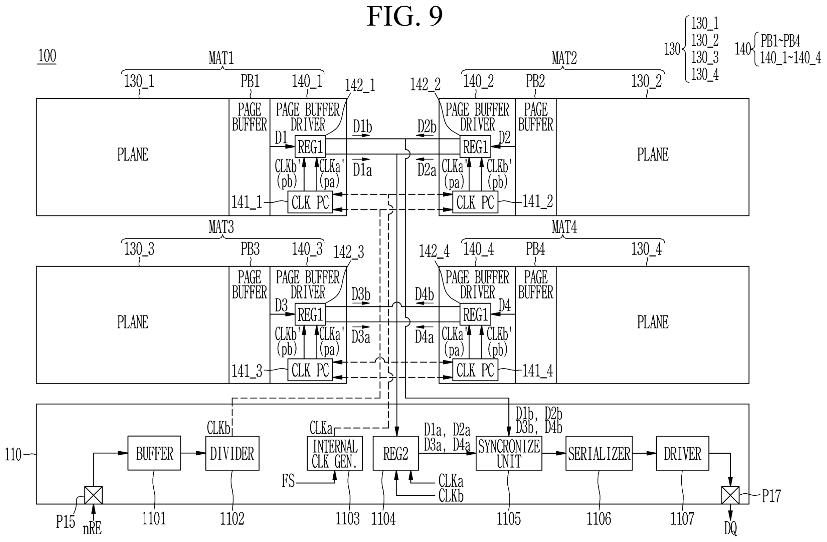

FIG. 9 is a diagram illustrating a non-volatile memory device including a plurality of mats according to some implementations. Specifically, FIG. 9 illustrates the configurations of a non-volatile memory device 100 centered on the output operation of data.

Referring to FIGS. 2, 6, and 9, the non-volatile memory device 100 may have a multi-mat structure, and the memory cell array 130 may include first to fourth memory cell arrays 130_1 to 130_4 corresponding to first to fourth mats MAT1 to MAT4.

The page buffer circuit 140 may include first to fourth page buffers PB1 to PB4 corresponding to each of the first to fourth memory cell arrays 130_1 to 130_4 and first to fourth page buffer drivers 140_1 to 140_4 electrically connected to each of the first to fourth page buffers PB1 to PB4.

The first memory cell array 130_1, the first page buffer PB1, and the first page buffer driver 140_1 operate as a first mat MAT1 and may perform at least one of a data input/output operation, a program operation, a read operation, and an erase operation.

The first memory cell array 130_1 may include at least one memory block electrically connected to the first page buffer PB1 as one plane.

The first page buffer PB1 corresponds to the page buffer PB of FIG. 8 and may sense and latch the first data D1 stored in the first memory cell array 130_1.

The first page buffer driver 140_1 receives first data D1 latched in the first page buffer PB1, receives one of clock signals CLKa, CLKb from the memory interface circuit 110, and provides the first data D1 to the memory interface circuit 110 by changing the path based on the clock signals CLKa, CLKb. The clock signals CLKa, CLKb may include an a clock signal CLKa generated through an oscillator within the non-volatile memory device 100 and a b clock signal CLKb generated based on a read enable signal nRE provided from outside the non-volatile memory device 100.

For example, the first page buffer driver 140_1 may provide the 1_a data D1a, which is partial data of the first data D1, to the memory interface circuit 110 through the a path pa based on the a clock signal CLKa. When the first page buffer driver 140_1 receives the b clock signal CLKb, it may provide the 1_b data D1b, which is partial data of the first data D1, to the memory interface circuit 110 through the b path pb.

The first page buffer driver 140_1 may include a first clock processing circuit 141_1 and a first register 142_1. The first clock processing circuit 141_1 receives an a clock signal CLKa and a b clock signal CLKb from the memory interface circuit 110, preprocesses the a clock signal CLKa and the b clock signal CLKb, and selects one of the preprocessed a clock signal CLKa' and the preprocessed b clock signal CLKb' and provides the selected one to the first register 142_1. The above preprocessing operation may include a duty correction operation for a clock signal, etc. According to some implementations, the first clock processing circuit 141_1 may provide the a clock signal CLKa and the b clock signal CLKb to the first register 142_1 in the order of the a clock signal CLKa and the b clock signal CLKb.

The first register 142_1 performs a latch operation based on the a clock signal CLKa to preload the 1_a data D1a, which is partial data of the first data D1, and the preloaded 1_a data D1a may be provided to an output driver 1107 in the memory interface circuit 110 through the a path pa. The first register 142_1 loads the 1_b data D1b, which is partial data of the first data D1, based on the b clock signal CLKb, and the loaded 1_b data D1b may be provided to a synchronize unit 1105 (e.g., a synchronizer) in the memory interface circuit 110 through the b path pb. In the present disclosure, the a path pa may mean a path between a register in a page buffer driver and an output register 1104 in a memory interface circuit 110, and the b path pb may mean a path between a register in a page buffer driver and a synchronize unit 1105 in a memory interface circuit 110, and the a path pa and the b path pb may be separate paths.

According to some implementations, the first clock processing circuit 141_1 may provide the a clock signal CLKa and the b clock signal CLKb to the first register 142_1 in the order of the a clock signal CLKa and the b clock signal CLKb, and the first register 142_1 may provide the first data D1 to the memory interface circuit 110 in the order of the 1_a data D1a and the 1_b data D1b.

The second memory cell array 130_2, the second page buffer PB2, and the second page buffer driver 140_2 operate as a second mat MAT2 and may perform at least one of a data input/output operation, a program operation, a read operation, and an erase operation.

The second memory cell array 130_2 may include at least one memory block electrically connected to the second page buffer PB2 as one plane.

The second page buffer PB2 corresponds to the page buffer PB of FIG. 8 and may sense and latch second data D2 stored in the second memory cell array 130_2.

The second page buffer driver 140_2 may include a second clock processing circuit 141_2 and a second register 142_2. Each of the second page buffer driver 140_2, the second clock processing circuit 141_2, and the second register 142_2 may correspond to the first page buffer driver 140_1, the first clock processing circuit 141_1, and the first register 142_1, respectively. For ease of explanation below, the second page buffer driver 140_2, the second clock processing circuit 141_2, and the second register 142_2 will be described with a focus on differences from the first page buffer driver 140_1, the first clock processing circuit 141_1, and the first register 142_1.

The second page buffer driver 140_2 receives second data D2 latched in the second page buffer PB2, receives one of clock signals CLKa, CLKb from the memory interface circuit 110, and provides the second data D2 to the memory interface circuit 110 by changing the path based on the clock signals CLKa, CLKb.

The second clock processing circuit 141_2 receives the a clock signal CLKa and the b clock signal CLKb from the memory interface circuit 110, preprocesses the a clock signal CLKa and the b clock signal CLKb, and selects one of the preprocessed a clock signal CLKa' and the b clock signal CLKb' and provides it to the second register 142_2.

The second register 142_2 performs a latch operation based on the a clock signal CLKa to preload 2_a data D2a, which is partial data of the second data D2, and the preloaded 2_a data D2a may be provided to the output driver 1107 in the memory interface circuit 110 through the a path pa. The second register 142_2 loads 2_b data D2b, which is partial data of the second data D2, based on the b clock signal CLKb, and the loaded 2_b data D2b may be provided to the synchronize unit 1105 in the memory interface circuit 110 through the b path pb.

The third memory cell array 130_3, the third page buffer PB3, and the third page buffer driver 140_3 operate as a third mat MAT3 and may perform at least one of a data input/output operation, a program operation, a read operation, and an erase operation.

The third memory cell array 130_3 may include at least one memory block electrically connected to the third page buffer PB3 as one plane.

The third page buffer PB3 corresponds to the page buffer PB of FIG. 8 and may sense and latch third data D3 stored in the third memory cell array 130_3.

The third page buffer driver 140_3 may include a third clock processing circuit 141_3 and a third register 142_3. Each of the third page buffer driver 140_3, the third clock processing circuit 141_3, and the third register 142_3 may correspond to the first page buffer driver 140_1, the first clock processing circuit 141_1, and the first register 142_1, respectively. For ease of explanation below, the third page buffer driver 140_3, the third clock processing circuit 141_3, and the third register 142_3 will be described with a focus on differences from the first page buffer driver 140_1, the first clock processing circuit 141_1, and the first register 142_1.

The third page buffer driver 140_3 receives third data D3 latched in the third page buffer PB3, receives one of clock signals CLKa, CLKb from the memory interface circuit 110, and provides the third data D3 to the memory interface circuit 110 by changing the path based on the clock signals CLKa, CLKb.

The third clock processing circuit 141_3 receives the a clock signal CLKa and the b clock signal CLKb from the memory interface circuit 110, preprocesses the a clock signal CLKa and the b clock signal CLKb, and selects one of the preprocessed a clock signal CLKa' and the b clock signal CLKb' and provides it to the third register 142_3.

The third register 142_3 performs a latch operation based on the a clock signal CLKa to preload 3_a data D3a, which is partial data of the third data D3, and the preloaded 3_a data D3a may be provided to the output driver 1107 in the memory interface circuit 110 through the a path pa. The third register 142_3 loads third_b data D3b, which is partial data of the third data D3, based on the b clock signal CLKb, and the loaded third_b data D3b may be provided to the synchronize unit 1105 in the memory interface circuit 110 through the b path pb.

The fourth memory cell array 130_4, the fourth page buffer PB4, and the fourth page buffer driver 140_4 operate as a fourth mat MAT4 and may perform at least one of a data input/output operation, a program operation, a read operation, and an erase operation.

The fourth memory cell array 130_4 may include at least one memory block electrically connected to the fourth page buffer PB4 as one plane.

The fourth page buffer PB4 corresponds to the page buffer PB of FIG. 8 and may sense and latch the fourth data D4 stored in the fourth memory cell array 130_4.

The fourth page buffer driver 140_4 may include a fourth clock processing circuit 141_4 and a fourth register 142_4. Each of the fourth page buffer driver 140_4, the fourth clock processing circuit 141_4, and the fourth register 142_4 may correspond to the first page buffer driver 140_1, the first clock processing circuit 141_1, and the first register 142_1, respectively. For ease of explanation below, the fourth page buffer driver 140_4, the fourth clock processing circuit 141_4, and the fourth register 142_4 will be described with a focus on differences from the first page buffer driver 140_1, the first clock processing circuit 141_1, and the first register 142_1.

The fourth page buffer driver 140_4 receives fourth data D4 latched in the fourth page buffer PB4, receives one of clock signals CLKa, CLKb from the memory interface circuit 110, and provides the fourth data D4 to the memory interface circuit 110 by changing the path based on the clock signals CLKa, CLKb.

The fourth clock processing circuit 141_4 receives the a clock signal CLKa and the b clock signal CLKb from the memory interface circuit 110, preprocesses the a clock signal CLKa and the b clock signal CLKb, and selects one of the preprocessed a clock signal CLKa' and the b clock signal CLKb' and provides it to the fourth register 142_4.

The fourth register 142_4 performs a latch operation based on the a clock signal CLKa to preload 4_a data D4a, which is partial data of the fourth data D4, and the preloaded 4_a data D4a may be provided to the output driver 1107 in the memory interface circuit 110 through the a path pa. The fourth register 142_4 loads 4_b data D4b, which is partial data of the fourth data D4, based on the b clock signal CLKb, and the loaded 4_b data D4b may be provided to the synchronize unit 1105 in the memory interface circuit 110 through the b path pb.

The memory interface circuit 110 may include a clock buffer 1101, a divider 1102, an internal clock generator 1103, an output register 1104, a synchronize unit 1105, a serializer 1106, and an output driver 1107.

The clock buffer 1101 may receive and buffer a read enable signal nRE, which is a toggle signal received from the fifth pin P15, and provide it to the divider 1102.

The divider 1102 may receive a read enable signal nRE and divide it into a b clock signal CLKb. The b clock signal CLKb may be provided to the clock processing circuit 141_1 to 141_4. According to some implementations, the frequency of the b clock signal CLKb may be reduced by half compared to the frequency of the read enable signal nRE, but the division ratio may be variously changed according to some implementations.

The internal clock generator 1103 may include an oscillator. The internal clock generator 1103 may receive a flag signal FS provided from the control logic circuit 120 and generate the a clock signal CLKa in response to receiving the flag signal FS.
flag signal FS to the internal clock generator 1103 in response to receiving the data output command DOUT. Accordingly, the internal clock generator 1103 may generate the a clock signal CLKa in response to the data output command DOUT (e.g., in response to the non-volatile memory device 100 receiving the data output command DOUT). The a clock signal CLKa may be provided to the clock processing circuit 141_1 to 141_4. According to some implementations, the internal clock generator 1103 may generate an a clock signal CLKa having a frequency that is the same as or similar to the frequency of the b clock signal CLKb.

The output register 1104 receives the a clock signal CLKa and the b clock signal CLKb, and performs a latch operation based on the a clock signal CLKa and the b clock signal CLKb to provide the 1_a to 4_a data D1a to D4a received from the first to fourth registers 142_1 to 142_4 to the synchronize unit 1105. According to some implementations, the output register 1104 may be a dual clock register that performs a latch operation on the 1_a to 4_a data D1a to D4a based on the a clock signal CLKa and the b clock signal CLKb.

The output register 1104 may buffer the 1_a to 4_a data data D1a to D4a based on the a clock signal CLKa and output the 1_a to 4_a data data D1a to D4a to the synchronize unit 1105 based on the b clock signal CLKb.

The synchronize unit 1105 receives the 1_a to 4_a data data D1a to D4a and the 1_b to 4_b data D1b to D4b, and adjusts the output timing of the 1_a to 4_a data D1a to D4a and the 1_b to 4_b data D1b to D4b, so as to sequentially output the 1_a to 4_a data D1a to D4a and the 1_b to 4_b data D1b to D4b and provide the first to fourth data D1 to D4 to the serializer 1106. For example, the synchronize unit 1105 may receive the 1_a data D1a and the 1_b data D1b and adjust the output timing of the 1_a data D1a and the 1_b data D1b to sequentially output the 1_a data D1a and the 1_b data D1b and provide the first data D1 to the serializer 1106.

The serializer 1106 and the output driver 1107 may serialize the first to fourth data D1 to D4 and increase the output frequency of the first to fourth data D1 to D4. The output driver 1107 may output a data signal DQ through the seventh pin P17 based on the data input/output voltage of the non-volatile memory device 100.

A non-volatile memory device 100 may separate a path for a preloading operation and a path for a loading operation through separation of the output paths pa, pb of the first to fourth registers 142_1 to 142_4. A non-volatile memory device 100 may improve the operating speed performance of the non-volatile memory device 100 without data collision by performing a preloading operation while a data signal DQ is output through path separation for a preloading operation and a loading operation. For example, when a storage device according to some implementations receives a write request of the plurality of random read patterns from a host device, the non-volatile memory device 100 may perform a data signal output operation and a preloading operation together to reduce the overall processing time for the write request of the plurality of random read patterns without data collision.

In FIG. 9, the non-volatile memory device 100 is illustrated as including four mats, but the number of mats is an example for explanation and the number of mats may vary depending on the implementations.

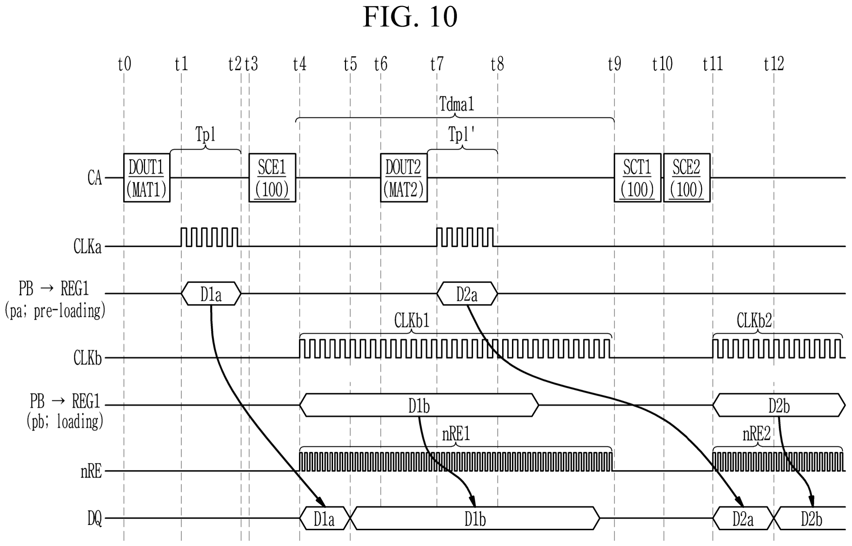

FIG. 10 is a timing diagram illustrating a method of operating a storage device according to some implementations. Specifically, FIG. 10 illustrates a method of operation of a storage device when a non-volatile memory device 100 sequentially receives data output packets for first and second mats MAT1, MAT2. Each data output packet may be based on a read request with a random read pattern.

Referring to FIGS. 2, 9, and 10, at time t0, the storage controller 200 may provide a first data output command DOUT1 for a first mat MAT1 to the non-volatile memory device 100.

At time t1, the internal clock generator 1103 may generate an a clock signal CLKa in response to the first data output command DOUT1 (e.g., in response to receiving the first data output command DOUT1 or in response to the non-volatile memory device 100 receiving the first data output command DOUT1) and provide the a clock signal CLKa to the first register 142_1.
Accordingly, the internal clock generator 1103 may generate the a clock signal CLKa in response to the non-volatile memory device 100 receiving the data output command DOUT. The first register 142_1 performs a latch operation on the 1_a data D1a, which is partial data of the first data D1, based on the a clock signal CLKa, and the 1_a data D1a latched in the first page buffer PB1 may be preloaded into the first register 142_1. Through the preloading operation, the 1_a data D1a may be provided from the first register 142_1 to the output driver 1107 in the memory interface circuit 110 through the a path pa. The period from the output of the first data output command DOUT1 to the time t2 when the first register 142_1 ends the preloading operation may be a preloading period Tpl. The preloading period Tpl may correspond to the timing parameter 'tWHR2' in JESD230G (a revised version of JESD230F.01; published in May 2023).

At time t3, the storage controller 200 may provide a first select chip enable command SCE1 corresponding to the first data output command DOUT1 to the non-volatile memory device 100.

At time t4, the storage controller 200 may provide a first read enable signal (nRE1) to the non-volatile memory device 100 based on the first select chip enable command SCE1. The clock buffer 1101 and divider 1102 may generate the b_1 clock signal CLKb1 based on the first read enable signal (nRE1). The b_1 clock signal CLKb1 is provided to the output register 1104 and may be provided to the first register 142_1 through the first clock processing circuit 141_1. The output register 1104 may perform a latch operation on the 1_a data D1a based on the b_1 clk signal CLKb1. The 1_a data D1a may be output from the output register 1104 and output as a data signal DQ through the seventh pin P17. The first register 142_1 performs a latch operation on the 1_b data D1b, which is partial data of the first data D1, based on the b_1 clk signal CLKb1, and the 1_b data D1b latched in the first page buffer PB1 may be loaded into the first register 142_1. Through the loading operation, the 1_b data D1b may be provided from the first register 142_1 to the synchronize unit 1105 within the memory interface circuit 110 through the b path pb.

At time t5, the 1_b data D1b may be output through the synchronize unit 1105 and output in the form of a data signal DQ through the seventh pin P17.

At time t6, the storage controller 200 may provide a second data output command DOUT2 for the second mat MAT2 to the non-volatile memory device 100 during a data output operation for the first data D1. A non-volatile memory device 100 may receive a second data output command DOUT2 between a first select chip enable command SCE1 corresponding to a first data output command DOUT1 and a first select chip terminate command SCT1 for the first select chip enable command SCE1.

At time t7, the internal clock generator 1103 may generate an a clock signal CLKa in response to receiving the second data output command DOUT2 and provide the a clock signal CLKa to the second register 142_2. While the first register 142_1 receives the b_1 clock signal CLKb1, the second register 142_2 may perform a latch operation on the 2_a data D2a, which is partial data of the second data D2, based on the a clock signal CLKa. The 2_a data D2a latched in the second page buffer PB2 may be preloaded into the second register 142_2. Through the preloading operation, the 2_a data D2a may be provided from the second register 142_2 to the output driver 1107 in the memory interface circuit 110 through the a path pa. The period from the output of the second data output command DOUT2 to the time t8 when the second register 142_2 ends the preloading operation may be a preloading period Tpl.

At time t9, the storage controller 200 may provide a first select chip terminate command SCT1 to the first select chip enable command SCE1 to the non-volatile memory device 100. The period from the output of the first select chip enable command SCE1 to the time t9, which is the time at which the output operation for the data signal DQ ends, may be a first data output period Tdma1 for the first data output command DOUT1.

By separating the a path pa for the preloading operation and the b path pb for the loading operation, the first data output period Tdma1 and the preloading period Tpl' for the second data output command DOUT2 may overlap simultaneously without data collision.

At time t10, the storage controller 200 may provide a second select chip enable command SCE2 corresponding to a second data output command DOUT2 to the non-volatile memory device 100. The storage controller 200 may provide a second select chip enable command SCE2 without any separate restriction immediately after the output of the first select chip terminate command SCT1 by overlapping the first data output period Tdma1 and the preloading period Tpl' for the second data output command DOUT2.

At time t11, the storage controller 200 may provide a second read enable signal (nRE2) to the non-volatile memory device 100 based on the second select chip enable command SCE2. The clock buffer 1101 and divider 1102 may generate the b_2 clock signal CLKb2 based on the second read enable signal (nRE2). The b_2 clock signal CLKb2 is provided to the output register 1104 and may be provided to the second register 142_2 through the second clock processing circuit 141_2. The output register 1104 may perform a latch operation on the 2_a data D2a based on the b_2 clk signal CLKb2. The 2_a data D2a may be output from the output register 1104 and output as a data signal DQ through the seventh pin P17. The second register 142_2 performs a latch operation on the 2_b data D2b, which is partial data of the second data D2, based on the b_2 clk signal CLKb2, and the 2_b data D2b latched in the second page buffer PB2 may be loaded into the second register 142_2. Through the loading operation, the 2_b data D2b may be provided from the second register 142_2 to the synchronize unit 1105 within the memory interface circuit 110 through the b path pb.

At time t12, the 2_b data D2b may be output through the synchronize unit 1105 and output in the form of a data signal DQ through the seventh pin P17.

The storage controller 200 may provide a select chip terminate command for the second select chip enable command SCE2 to the non-volatile memory device 100 and terminate a data signal DQ output operation according to the second data output command DOUT2.

A non-volatile memory device 100 may improve the overall speed performance of the non-volatile memory device 100 by performing a preloading operation while outputting a data signal DQ through path separation for the preloading operation and the loading operation.

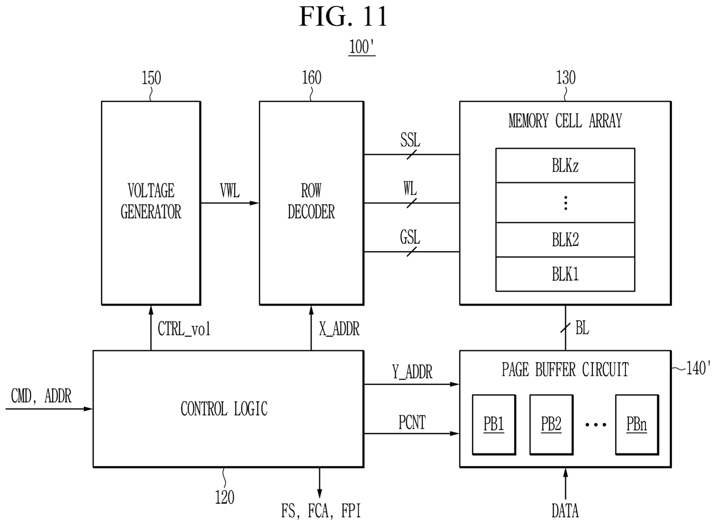

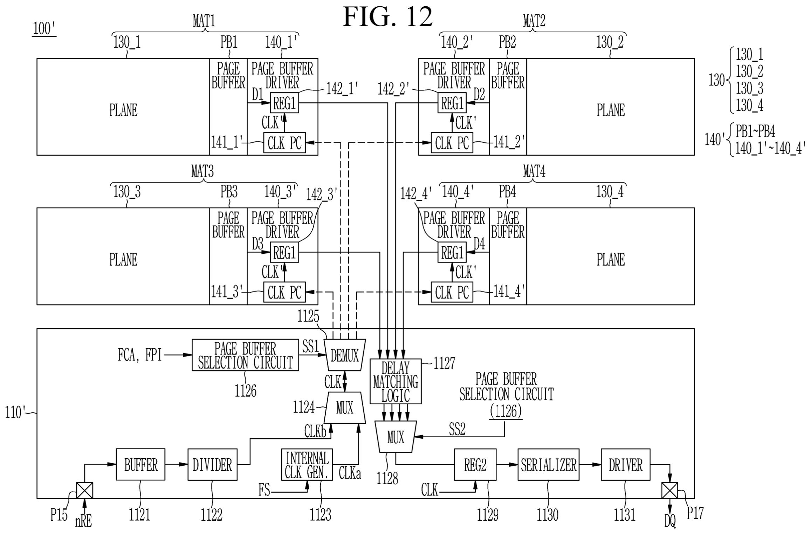

FIG. 11 is a block diagram illustrating a non-volatile memory device according to some implementations. FIG. 12 is a diagram illustrating a non-volatile memory device including a plurality of mats according to some implementations. Specifically, FIG. 12 illustrates configurations of a non-volatile memory device 100' centered on the output operation of data.

Each of the non-volatile memory device 100', the memory interface circuit 110', and the page buffer circuit 140' of FIGS. 11 and 12 may correspond to the non-volatile memory device 100, the memory interface circuit 110, and the page buffer circuit 140 of FIGS. 6 and 9, respectively. For ease of explanation below, the non-volatile memory device 100', the memory interface circuit 110', and the page buffer circuit 140' will be described with a focus on differences from the non-volatile memory device 100, the memory interface circuit 110, and the page buffer circuit 140 of FIGS. 6 and 9.

Referring to FIGS. 11 and 12, the control logic circuit 120 may output a voltage control signal CTRL_vol, a row address X-ADDR, a column address Y-ADDR, a flag signal FS, and a final column address FCA.

According to some implementations, the control logic circuit 120 may output a flag signal FS, a final column address FCA, and subsequent page buffer information FPI in response to receiving the data output command DOUT of FIG. 3. The final column address FCA may include address information for the final column targeted by the data output command. Subsequent page buffer information FPI may include page buffer information for a subsequently input data output command when data output commands are received sequentially.

According to some implementations, the output flag signal FS, the final column address FCA, and the subsequent page buffer information FPI may be provided to the memory interface circuit 110'. According to some implementations, the memory interface circuit 110' may generate an internal clock signal, the a clock signal CLKa, based on the flag signal FS. According to some implementations, the memory interface circuit 110' may distinguish clock signals in a time-series manner based on the final column address FCA and subsequent page buffer information FPI and distribute them to the page buffer drivers 140_1' to 140_4'.

The page buffer circuit 140' may include first to fourth page buffers PB1 to PB4 corresponding to each of the first to fourth memory cell arrays 130_1 to 130_4 and first to fourth page buffer drivers 140_1' to 140_4' electrically connected to each of the first to fourth page buffers PB1 to PB4.

The first page buffer driver 140_1' may receive first data D1 latched in the first page buffer PB1, receive a merge clock signal CLK from the memory interface circuit 110', and provide the first data D1 to the memory interface circuit 110' based on the merge clock signal CLK. The merge clock signal CLK is a signal in which an a clock signal CLKa generated through an oscillator within a non-volatile memory device 100' and a b clock signal CLKb generated based on a read enable signal nRE provided from outside the non-volatile memory device 100 are merged, and may be generated based on either the a clock signal CLKa or the b clock signal CLKb.

The first page buffer driver 140_1' may include a first clock processing circuit 141_1' and a first register 142_1'. The first clock processing circuit 141_1' may receive a merge clock signal CLK from the memory interface circuit 110', preprocess the merge clock signal CLK, and provide the preprocessed merge clock signal CLK' to the first register 142_1'. The above preprocessing operation may include a duty correction operation for a clock signal, etc.

The first register 142_1' may perform a latch operation based on a merge clock signal CLK to preload partial data of the first data D1 and provide it to the delay matching logic 1127 in the memory interface circuit 110'. Thereafter, the first register 142_1' may load the remaining data of the first data D1 based on the merge clock signal CLK and provide it to the delay matching logic 1127 in the memory interface circuit 110'.

The second page buffer driver 140_2' may include a second clock processing circuit 141_2' and a second register 142_2'. Each of the second page buffer driver 140_2', the second clock processing circuit 141_2', and the second register 142_2' may correspond to the first page buffer driver 140_1', the first clock processing circuit 141_1', and the first register 142_1', respectively. For ease of explanation below, the second page buffer driver 140_2', the second clock processing circuit 141_2', and the second register 142_2' will be described with a focus on differences from the first page buffer driver 140_1', the first clock processing circuit 141_1', and the first register 142_1'.

The second page buffer driver 140_2' may receive second data D2 latched in the second page buffer PB2, receive a merge clock signal CLK from the memory interface circuit 110', and provide second data D2 to the memory interface circuit 110' based on the merge clock signal CLK.

The second clock processing circuit 141_2' may receive a merge clock signal CLK from the memory interface circuit 110', preprocess the merge clock signal CLK, and provide the preprocessed merge clock signal CLK' to the second register 142_2'.

The second register 142_2' may perform a latch operation based on a merge clock signal CLK to preload partial data of the second data D2 and provide it to the delay matching logic 1127 in the memory interface circuit 110'. Thereafter, the second register 142_2' may load the remaining data of the second data D2 based on the merge clock signal CLK and provide it to the delay matching logic 1127 in the memory interface circuit 110'.

The third page buffer driver 140_3' may include a third clock processing circuit 141_3' and a third register 142_3'. Each of the third page buffer driver 140_3', the third clock processing circuit 141_3', and the third register 142_3' may correspond to the first page buffer driver 140_1', the first clock processing circuit 141_1', and the first register 142_1', respectively. For ease of explanation below, the third page buffer driver 140_3', the third clock processing circuit 141_3', and the third register 142_3' will be described with a focus on differences from the first page buffer driver 140_1', the first clock processing circuit 141_1', and the first register 142_1'.

The third page buffer driver 140_3' may receive third data D3 latched in the third page buffer PB3, receive a merge clock signal CLK from the memory interface circuit 110', and provide the third data D3 to the memory interface circuit 110' based on the merge clock signal CLK.

The third clock processing circuit 141_3' may receive a merge clock signal CLK from the memory interface circuit 110', preprocess the merge clock signal CLK, and provide the preprocessed merge clock signal CLK' to the third register 142_3'.

The third register 142_3' may perform a latch operation based on a merge clock signal CLK to preload partial data of the third data D3 and provide it to the delay matching logic 1127 in the memory interface circuit 110'. Thereafter, the third register 142_3' may load the remaining data of the third data D3 based on the merge clock signal CLK and provide it to the delay matching logic 1127 in the memory interface circuit 110'.

The fourth page buffer driver 140_4' may include a fourth clock processing circuit 141_4' and a fourth register 142_4'. Each of the fourth page buffer driver 140_4', the fourth clock processing circuit 141_4', and the fourth register 142_4' may correspond to the first page buffer driver 140_1', the first clock processing circuit 141_1', and the first register 142_1', respectively. For ease of explanation below, the fourth page buffer driver 140_4', the fourth clock processing circuit 141_4', and the fourth register 142_4' will be described with a focus on differences from the first page buffer driver 140_1', the first clock processing circuit 141_1', and the first register 142_1'.

The fourth page buffer driver 140_4' may receive fourth data D4 latched in the fourth page buffer PB4, receive a merge clock signal CLK from the memory interface circuit 110', and provide the fourth data D4 to the memory interface circuit 110' based on the merge clock signal CLK.

The fourth clock processing circuit 141_4' may receive a merge clock signal CLK from the memory interface circuit 110', preprocess the merge clock signal CLK, and provide the preprocessed merge clock signal CLK' to the fourth register 142_4'.

The fourth register 142_4' may perform a latch operation based on a merge clock signal CLK to preload partial data of the fourth data D4 and provide it to the delay matching logic 1127 in the memory interface circuit 110'. Thereafter, the fourth register 142_4' may load the remaining data of the fourth data D4 based on the merge clock signal CLK and provide it to the delay matching logic 1127 in the memory interface circuit 110'.

The memory interface circuit 110' may include a clock buffer 1121, a divider 1122, an internal clock generator 1123, a first multiplexer 1124, a demultiplexer 1125, a page buffer selection circuit 1126, delay matching logic 1127, a second multiplexer 1128, an output register 1129, a serializer 1130, and an output driver 1131.

The clock buffer 1121 corresponds to the clock buffer 1101 of FIG. 9 and may receive and buffer a read enable signal nRE, which is a toggle signal received from the fifth pin P15, and provide it to the divider 1122.

The divider 1122 corresponds to the divider 1102 of FIG. 9, and the divider 1102 may receive a read enable signal nRE and divide it into a b clock signal CLKb. The b clock signal CLKb may be provided to the first multiplexer 1124.

The internal clock generator 1123 corresponds to the internal clock generator 1103 of FIG. 9, receives a flag signal FS provided from the control logic circuit 120, and may generate an a clock signal CLKa in response to receiving the flag signal FS. The a clock signal CLKa may be provided to the first multiplexer 1124.

The first multiplexer 1124 may receive the a clock signal CLKa and the b clock signal CLKb, and generate a merge clock signal CLK by merging the a clock signal CLKa and the b clock signal CLKb. The merge clock signal CLK may be based on either the a clock signal CLKa or the b clock signal CLKb. The merge clock signal CLK may be based on both the a clock signal CLKa and the b clock signal CLKb.

The demultiplexer 1125 may provide a merge clock signal CLK to any one of the first to fourth clock processing circuits 141_1' to 141_4' based on the first selection signal SS1 provided from the page buffer selection circuit 1126.

The page buffer selection circuit 1126 may receive the final column address FCA and page buffer information FPI from the control logic circuit 120 and generate first and second selection signals SS1, SS2. The first selection signal SS1 may be provided to a demultiplexer 1125, and the second selection signal SS2 may be provided to a second multiplexer 1128.

Through the operation of the demultiplexer 1125 and the page buffer selection circuit 1126, a merge clock signal CLK based on one data output packet may be distinguished in a time-series manner based on the first selection signal SS1, and the distinguished merge clock signal CLK may be distributed to the page buffer drivers 140_1' to 140_4'.

For example, when data output commands are received sequentially and a merge clock signal CLK for a preceding data output command is generated, when a loading operation for the preceding data output command is completed through the operation of the demultiplexer 1125 and the page buffer selection circuit 1126, the remainder of the merge clock signal CLK may be used for a preloading operation for a subsequent data output command. Through the operation of the demultiplexer 1125 and page buffer selection circuit 1126 as described above, the loading operation for the preceding data output command and the preloading operation for the subsequent data output command may be separated in time series.

The delay matching logic 1127 may receive the first to fourth data D1 to D4, adjust the output timing of the first to fourth data D1 to D4, and provide the first to fourth data D1 to D4 to the second multiplexer 1128. For example, the delay matching logic 1127 may delay the output timing of data based on a preloading operation for a subsequent data output command, so that data based on a loading operation for a preceding data output command may be provided to the output register 1129 first.

According to some implementations, the second multiplexer 1128 may provide one of the first to fourth data D1 to D4 to the output register 1129 based on a second selection signal SS2 provided from the page buffer selection circuit 1126.

Through the operation of the delay matching logic 1127 and the second multiplexer 1128, data collision between data based on a loading operation for a preceding data output command and data based on a preloading operation for a subsequent data output command may be prevented, thereby improving the reliability of the output operation of the data signal DQ.

The output register 1129 may perform a latch operation based on a merge clock signal CLK to provide the first to fourth data D1 to D4 received from the first to fourth registers 142_1 to 1'42_4' to the serializer 1130.

The serializer 1130 and the output driver 1131 each correspond to the serializer 1106 and the output driver 1107 of FIG. 9, respectively, and the serializer 1130 may serialize the first to fourth data D1 and increase the output frequency of the first to fourth data D1. The output driver 1131 may output a data signal DQ through the seventh pin P17 based on the data input/output voltage of the non-volatile memory device 100'.

A non-volatile memory device 100' may separate a loading operation for a preceding data output command and a preloading operation for a subsequent data output command in a time-series manner by providing separate merge clock signals CLK. A non-volatile memory device 100' may improve the operating speed performance of the non-volatile memory device 100' without data collision by performing a preloading operation while a data signal DQ is output through time-series separation of a preloading operation and a loading operation. For example, when a storage device according to some implementations receives a write request of the plurality of random read patterns from a host device, the non-volatile memory device 100' may perform a data signal output operation and a preloading operation together to reduce the overall processing time for the write request of the plurality of random read patterns without data collision.

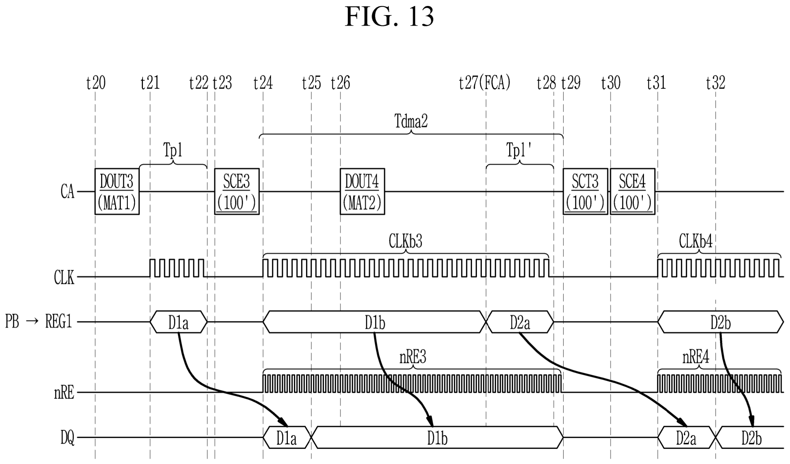

FIG. 13 is a timing diagram illustrating a method of operating a storage device according to some implementations. Specifically, FIG. 13 illustrates a method of operation of a storage device when a non-volatile memory device 100' sequentially receives data output packets for the first and second mats MAT1, MAT2. Each data output packet may be based on a read request with a random read pattern.

Referring to FIGS. 2, 12, and 13, at time t20, the storage controller 200 may provide a third data output command DOUT3 for the first mat MAT1 to the non-volatile memory device 100'.

At time t21, the internal clock generator 1123 generates an a clock signal CLKa in response to receiving the third data output command DOUT3, and the first register 142_1' may receive a merge clock signal CLK based on the a clock signal CLKa. The first register 142_1' performs a latch operation on the 1_a data D1a, which is partial data of the first data D1, based on the merge clock signal CLK, and the 1_a data D1a latched in the first page buffer PB1 may be preloaded into the first register 142_1'. Through the preloading operation, the 1_a data D1a may be provided from the first register 142_1' to the delay matching logic 1127 in the memory interface circuit 110'. The period from the output of the third data output command DOUT3 to the time t22 when the first register 142_1' ends the preloading operation may be a preloading period Tpl.

At time t23, the storage controller 200 may provide a third select chip enable command SCE3 corresponding to the first data output packet DOUT3 to the non-volatile memory device 100'.

At time t24, the storage controller 200 may provide a third read enable signal (nRE3) to the non-volatile memory device 100' based on the third select chip enable command SCE3. The clock buffer 1121 and divider 1122 may generate the b_3 clock signal CLKb3 based on the third read enable signal (nRE3). A merge clock signal CLK based on the b_3 clock signal CLKb3 is provided to an output register 1129 and may be provided to a first register 142_1' through a first clock processing circuit 141_1'. The output register 1129 may perform a latch operation on the 1_a data D1a based on the merge clock signal CLK. The 1_a data D1a may be output from the output register 1129 and output as a data signal DQ through the seventh pin P17. The first register 142_1' performs a latch operation on the 1_b data D1b, which is partial data of the first data D1, based on the merge clock signal CLK, and the 1_b data D1b latched in the first page buffer PB1 may be loaded into the first register 142_1'. Through the loading operation, the 1_b data D1b may be provided from the first register 142_1' to the delay matching logic 1127 in the memory interface circuit 110'.

At time t25, the 1_b data D1b may be output through the delay matching logic 1127 and output in the form of a data signal DQ through the seventh pin P17.

At time t26, the storage controller 200 may provide a fourth data output command DOUT4 for the second mat MAT2 to the non-volatile memory device 100' during a data output operation for the first data D1. The non-volatile memory device 100' may receive a fourth data output command DOUT4 between a third select chip enable command SCE3 corresponding to a third data output command DOUT3 and a third select chip terminate command SCT3 for the third select chip enable command SCE3.

At time t27, the page buffer selection circuit 1126 may provide a first selection signal SS1 to the demultiplexer 1125 based on the final column address FCA and the page buffer information FPI. The demultiplexer 1125 may provide a merge clock signal CLK based on the b_3 clock signal CLKb3 to the second register 142_2' through the second clock processing circuit 141_2' based on the first selection signal SS1. The demultiplexer 1125 may stop providing the merge clock signal CLK to the first clock processing circuit 141_1' based on the first selection signal SS1. While the data signal DQ for the 1_b data D1b is output, the second register 142_2' may perform a latch operation on the 2_a data D2a, which is partial data of the second data D2, based on the merge clock signal CLK. The 2_a data D2a latched in the second page buffer PB2 may be preloaded into the second register 142_2'. Through the preloading operation, the 2_a data D2a may be provided from the second register 142_2' to the delay matching logic 1127 in the memory interface circuit 110'. The period from time t27, when the second register 142_2' receives the merge clock signal CLK, to time t28, when the second register 142_2' ends the preloading operation, may be a preloading period Tpl'.

At time t29, the storage controller 200 may provide a third select chip terminate command SCT3 to the third select chip enable command SCE3 to the non-volatile memory device 100'. The period from the output of the third select chip enable command SCE3 to the time t30 when the output operation for the data signal DQ ends may be a second data output period Tdma2 for the third data output command DOUT3.

By providing time-series separation of the merge clock signal CLK, the second data output period Tdma2 and the preloading period Tpl for the third data output command DOUT3 may overlap simultaneously without data collision.

At time t30, the storage controller 200 may provide a fourth select chip enable command SCE4 corresponding to a fourth data output command DOUT4 to the non-volatile memory device 100'. The storage controller 200 may provide a fourth select chip enable command SCE4 without any separate restriction immediately after the output of the third select chip terminate command SCT3 by overlapping the second data output period Tdma2 and the preloading period Tpl for the fourth data output command DOUT4.

At time t31, the storage controller 200 may provide a fourth read enable signal (nRE4) to the non-volatile memory device 100' based on the fourth select chip enable command SCE4. The clock buffer 1121 and divider 1122 may generate the b_4 clock signal CLKb4 based on the fourth read enable signal (nRE4). A merge clock signal CLK based on the b_4 clock signal CLKb3 is provided to an output register 1129 and may be provided to a second register 142_2' through a second clock processing circuit 141_2'. The output register 1129 may perform a latch operation on the 2_a data D2a based on the merge clock signal CLK. The 2_a data D2a may be output from the output register 1129 and output as a data signal DQ through the seventh pin P17. The second register 142_2' performs a latch operation on the 2_b data D2b, which is partial data of the second data D2, based on the merge clock signal CLK, and the 2_b data D2b latched in the second page buffer PB2 may be loaded into the second register 142_2'. Through the loading operation, the 2_b data D2b may be provided from the second register 142_2' to the delay matching logic 1127 in the memory interface circuit 110'.

At time t32, the 2_b data D2b may be output through the delay matching logic 1127 and output in the form of a data signal DQ through the seventh pin P17.

The storage controller 200 may provide a select chip terminate command for the fourth select chip enable command SCE4 to the non-volatile memory device 100' and terminate a data signal DQ output operation according to the fourth data output command DOUT4.

A non-volatile memory device 100' may improve the overall speed performance of the non-volatile memory device 100' by performing a preloading operation while outputting a data signal DQ through providing time-series separation of a merge clock signal CLK.

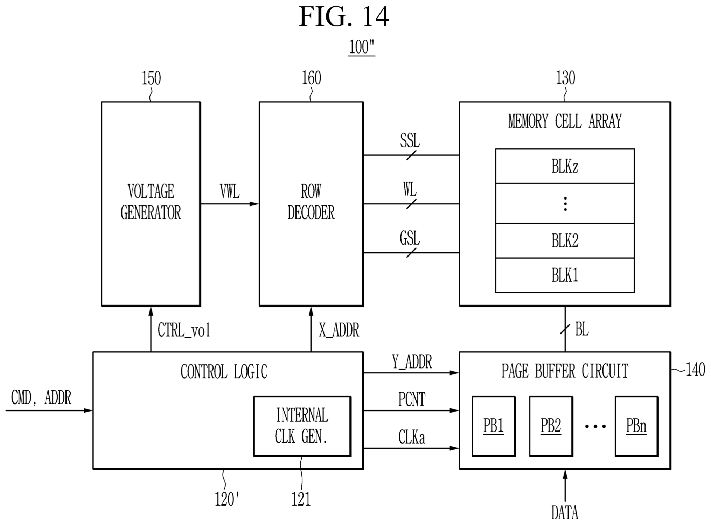

FIG. 14 is a block diagram illustrating a non-volatile memory device according to some implementations. The non-volatile memory device 100" of FIG. 14 may correspond to the non-volatile memory device 100 of FIG. 6. For ease of explanation below, the non-volatile memory device 100" will be described focusing on the differences from the non-volatile memory device 100 of FIG. 6.

The control logic circuit 120' of the non-volatile memory device 100" may further include an internal clock generator 121 compared to the control logic circuit 120 of FIG. 6. The internal clock generator 121 may correspond to the internal clock generator 1103 of FIG. 9 and the internal clock generator 1123 of FIG. 12.

In response to the non-volatile memory device 100" receiving the data output command DOUT of FIG. 3, the internal clock generator 121 may generate an a clock signal CLKa, which is an internal clock signal. The a clock signal CLKa may be provided to the page buffer circuit 140.

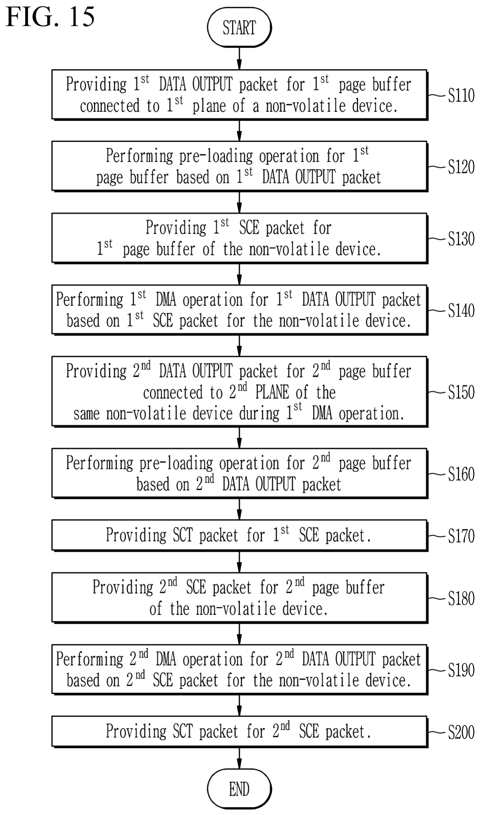

FIG. 15 is a flowchart illustrating a method of operating a storage device according to some implementations.

Referring to FIG. 15, the storage controller 200 provides a first data output packet (e.g., a first data output command) for the first page buffer of the first plane to the non-volatile memory device (S110).

Prior to operation S110, the first page buffer may sense and latch first data stored in the first plane, which is a memory cell array.

The non-volatile memory device performs a preloading operation based on the first data output packet (S120).

A first register connected to the first page buffer may preload a portion of the first data based on an internal clock signal in response to receiving a first data output packet.

The storage controller 200 provides a first select chip enable command for the first page buffer to the non-volatile memory device (S130).

The storage controller 200 may subsequently provide a first select chip enable command to the non-volatile memory device after providing the first data output packet.

The non-volatile memory device performs a first data output operation for a first data output packet based on a first select chip enable command (S140).

A portion of the first data preloaded into the first register may be output in the form of a data signal through the memory interface circuit. The first register loads the remainder of the first data based on a clock signal generated through a read enable signal, and the remainder of the loaded first data may be output in the form of a data signal through a memory interface circuit.

The storage controller 200 provides a second data output packet (e.g., a second data output command) for the second page buffer of the second plane to the non-volatile memory device during the first data output operation (S150).

Prior to operation S150, the second page buffer may sense and latch second data stored in the second plane, which is a memory cell array. While the non-volatile memory device outputs the first data of the first plane in the form of a data signal, the storage controller 200 may provide the non-volatile memory device with a second data output packet for the second page buffer.

The non-volatile memory device performs a preloading operation based on the second data output packet (S160).

The non-volatile memory device may perform a preloading operation based on a second data output packet while performing a first data output operation on first data.

Taking the non-volatile memory device 100 of FIG. 9 as an example, the first register may perform a loading operation on the first data D1 through the b path pb based on the b clock signal CLKb. During a loading operation for the first data D1, the second register connected to the second page buffer may preload a portion of the second data through the a path pa based on the a clock signal CLKa, which is an internal clock signal, in response to receiving the second data output packet.

Taking the non-volatile memory device 100' of FIG. 12 as an example, a first register may perform a loading operation on first data D1 through a portion of a merge clock signal CLK, and then a second register may preload a portion of second data based on the remainder of the merge clock signal CLK in response to receiving a second data output packet.

The storage controller 200 provides a select chip terminate command for a first select chip enable command to a non-volatile memory device (S170).

The storage controller 200 may subsequently provide a select chip terminate command for the first select chip enable command to the non-volatile memory device after providing the second data output packet.

The storage controller 200 provides a second select chip enable command for the second page buffer to the non-volatile memory device (S180).

The storage controller 200 may, after providing a select chip terminate command for a first select chip enable command, subsequently provide a second select chip enable command corresponding to a second data output packet to the non-volatile memory device.

The non-volatile memory device performs a second data output operation for a second data output packet based on a second select chip enable command (S190).

A portion of the second data preloaded into the second register may be output in the form of a data signal through the memory interface circuit. The second register loads the remainder of the second data based on a clock signal generated through a read enable signal, and the remainder of the loaded second data may be output in the form of a data signal through a memory interface circuit.

The storage controller 200 provides a select chip terminate command for a second select chip enable command to a non-volatile memory device (S200).

The storage controller 200 may subsequently provide a select chip terminate command for a second select chip enable command to the non-volatile memory device after providing the second data output packet.

According to the implementations, the non-volatile memory device may separate paths for preloading operations and paths for loading operations, or may separate preloading operations and loading operations in a time-series manner. In some implementations, by separating the preloading operation and the loading operation, the non-volatile memory device may perform the preloading operation during the data signal output operation.

According to some implementations, the storage device may reduce the overall processing time for a write request of the plurality of random read patterns without data collision through simultaneous operation of a data signal output operation and a preloading operation.

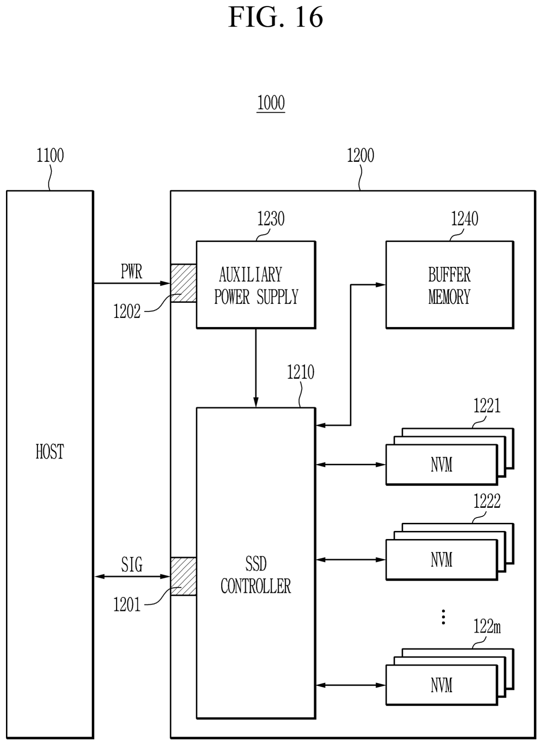

FIG. 16 is a block diagram illustrating an SSD system to which a storage device is applied according to some implementations. Referring to FIG. 16, the SSD system 1000 includes a host 1100 and an SSD 1200.

The SSD 1200 may exchange signals SIG with the host 1100 through the signal connector 1201 and receive power PWR through the power connector 1202. The SSD 1200 may include an SSD controller 1210, a plurality of flash memories 1221 to 122m, an auxiliary power supply 1230, and a buffer memory 1240. A plurality of flash memories 1221 to 122m may be respectively connected to the SSD controller 1210 through a plurality of channels.

The SSD controller 1210 may control the plurality of flash memories 1221 to 122m in response to a signal SIG received from the host 1100. The SSD controller 1210 may store a signal generated internally or transmitted from the outside (e.g., a signal (SIG) received from the host 1100) in the buffer memory 1240.

The SSD controller 1210 may be implemented as a storage controller described above with reference to FIGS. 1 to 15. For example, the SSD controller 1210 may transmit commands/addresses through pins that are different from those that transmit data through one channel. The SSD controller 1210 may control data input/output operations of each of the flash memories 1221 to 122m by providing data output packets, data input packets, as well as select chip enable commands, select chip terminate commands, etc. through pins different from the pins that transmit data. The SSD controller 1210 may improve the efficiency of data input/output operations through sequences for data output packets, select chip enable commands, select chip terminate commands, etc.

Multiple flash memories 1221 to 122m may operate under the control of the SSD controller 1210. The auxiliary power supply 1230 is connected to the host 1100 via a power connector 1202. Each of the plurality of flash memories 1221 to 122m may be implemented as a non-volatile memory device as described above with reference to FIGS. 1 to 15. For example, each of the plurality of flash memories 1221 to 122m may receive commands/addresses through pins that are different from the pins that receive data. A plurality of flash memories 1221 to 122m may perform data input/output operations along with efficient preloading operations and loading operations based on data output packets, data input packets, as well as select chip enable commands, select chip terminate commands, etc. According to some implementations, each of the flash memories 1221 to 122m may reduce the overall processing time for write requests of the plurality of random read patterns without data collision through simultaneous operation of data output operations and preloading operations.

The auxiliary power supply 1230 may be connected to the host 1100 via the power connector 1202. The auxiliary power supply 1230 may receive power PWR from the host 1100 and charge it. The auxiliary power supply 1230 may provide power to the SSD 1200 when the power supply from the host 1100 is not smooth.

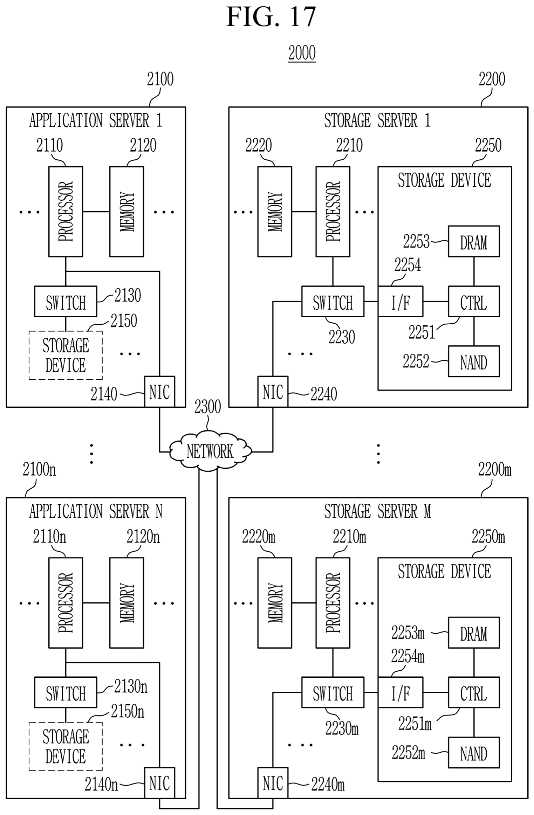

FIG. 17 is a block diagram illustrating a data center to which a storage device according to some implementations is applied. Referring to FIG. 17, the network system 2000 is a facility that collects various types of data and provides services and may be referred to as a data center or data storage center. The network system 2000 may include application servers 2100 to 2100n and storage servers 2200 to 2200m, and the application servers 2100 to 2100n and storage servers 2200 to 2200m may be referred to as computing nodes. The number of application servers 2100 to 2100n and the number of storage servers 2200 to 2200m may be variously selected depending on the implementations, and the number of application servers 2100 to 2100n and the number of storage servers 2200 to 2200m may be different from each other.

Application servers 2100 to 2100n and storage servers 2200 to 2200m may communicate with each other via a network 2300. The network 2300 may be implemented using FC (Fibre Channel) or Ethernet. At this time, FC is a medium used for high-speed data transmission, and an optical switch that provides high performance/high availability may be used. According to the access method of the network 2300, the storage servers 2200 to 2200m may be provided as file storage, block storage, or object storage.

In some implementations, the network 2300 may be a storage-only network, such as a Storage Area Network (SAN). For example, the SAN may be an FC-SAN that utilizes an FC network and is implemented according to the FC Protocol (FCP). In some implementations, the SAN may be an IP-SAN utilizing a TCP/IP network and implemented according to the iSCSI (SCSI over TCP/IP or Internet SCSI) protocol. In some implementations, the network 2300 may be a general network, such as a TCP/IP network. For example, the network 2300 may be implemented according to protocols such as FCoE (FC over Ethernet), NAS (Network Attached Storage), and NVMe-oF (NVMe over Fabrics).

Below, the explanation will focus on the application server 2100 and the storage server 2200. The description of the application server 2100 may also apply to other application servers 2100n, and the description of the storage server 2200 may also apply to other storage servers 2200m.

The application server 2100 may include a processor 2110 and memory 2120. The processor 2110 may control the overall operation of the application server 2100 and access the memory 2120 to execute instructions and/or data loaded into the memory 2120. According to some implementations, the number of processors 2110 and the number of memories 2120 included in the application server 2100 may be selected in various ways. In some implementations, the processor 2110 and memory 2120 may be configured as a processor-memory pair. In some implementations, the number of processors 2110 and memories 2120 may be configured differently.

The application server 2100 may further include a storage device 2150. The number of storage devices 2150 included in the application server 2100 may be selected in various ways depending on the implementations. The processor 2110 may provide commands to the storage device 2150, and the storage device 2150 may operate in response to the commands received from the processor 2110. However, the present disclosure is not limited thereto, and the application server 2100 may not include a storage device 2150.

The application server 2100 may further include a switch 2130 and a network interface card NIC 2140. The switch 2130 may selectively connect the processor 2110 and the storage device 2150 or selectively connect the NIC 2140 and the storage device 2150 under the control of the processor 2110. The NIC 2140 may include a wired interface, a wireless interface, a Bluetooth interface, an optical interface, etc. In some implementations, the processor 2110 and the NIC 2140 may be integrated into one. In some implementations, the storage device 2150 and the NIC 2140 may be integrated into one.

The application server 2100 may store data requested to be stored by a user or client in one of the storage servers 2200 to 2200m via a network 2300. Additionally, the application server 2100 may obtain data requested by a user or client from one of the storage servers 2200 to 2200m through the network 2300. For example, the application server 2100 may be implemented as a web server or a DBMS (Database Management System).

An application server 2100 may access a memory 2120n or a storage device 2150n included in another application server 2100n via a network 2300, or may access a memory 2220, 2220m or a storage device 2250, 2250m included in a storage server 2200, 2200m via a network 2300. Accordingly, the application server 2100 may perform various operations on data stored in the application server 2100, 2100n and/or the storage server 2200, 2200m. For example, the application server 2100 may execute commands to move or copy data between application servers 2100, 2100n and/or storage servers 2200, 2200m. In this case, data may be transferred over the network 2300 in an encrypted state for security or privacy.

The storage server 2200 may include a processor 2210 and memory 2220. The processor 2210 may control the overall operation of the storage server 2200 and access the memory 2220 to execute commands and/or data loaded into the memory 2220. According to the implementations, the number of processors 2210 and the number of memories 2220 included in the storage server 2200 may be selected in various ways. In some implementations, the processor 2210 and the memory 2220 may be configured as a processor-memory pair. In some implementations, the number of processors 2210 and memories 2220 may be configured differently.

The processor 2210 may include a single core processor or a multi-core processor. For example, the processor 2210 may include a general-purpose processor, a CPU (Central Processing Unit), a GPU (Graphics Processing Unit), a DSP (Digital Signal Processor), an MCU (Microcontroller), a microprocessor, a network processor, an embedded processor, an FPGA (field programmable gate array), an ASIP (application-specific instruction set processor), an ASIC (application-specific integrated circuit processor), etc.

The storage server 2200 may further include at least one storage device 2250. The number of storage devices 2250 included in the storage server 2200 may be selected in various ways depending on the implementations. The storage device 2250 may include a controller 2251, a plurality of NAND flashes 2252, DRAM 2253, and an interface 2254. Below, the configuration and operation of the storage device 2250 will be described. The following description of the storage device 2250 may also apply to other storage devices 2150, 2150n, 2250m.

The interface 2254 may provide a physical connection between the processor 2210 and the controller 2251 and a physical connection between the NIC 2240 and the controller 2251. For example, the interface 2254 may be implemented in a DAS (Direct Attached Storage) manner that directly connects the storage device 2250 with a dedicated cable. Additionally, for example, the interface 2254 may be implemented in various interface methods such as ATA (Advanced Technology Attachment), SATA (Serial ATA), e-SATA (external SATA), SCSI (Small Computer Small Interface), SAS (Serial Attached SCSI), PCI (Peripheral Component Interconnection), PCIe (PCI express), NVMe (NVM express), IEEE 1394, USB (universal serial bus), SD (secure digital) card, MMC (multi-media card), eMMC (embedded multi-media card), CF (compact flash) card interface, etc.

The controller 2251 may control the overall operation of the storage device 2250. The controller 2251 may program data into a plurality of NAND flashes 2252 in response to a program command or read data from a plurality of NAND flashes 2252 in response to a read command. For example, the program commands and/or read commands may be provided through or directly to the processor 2210 from a processor 2210 within a storage server 2200, a processor 2210m within another storage server 2200m, or a processor 2110, 2110n within an application server 2100, 2100n.

The plurality of NAND flashes 2252 may include a plurality of NAND flash memory cells. In some implementations, the plurality of NAND flashes 2252 may include the plurality of non-volatile memories connected to one channel. However, the present disclosure is not limited thereto, and the storage device 2250 may include non-volatile memory other than NAND flash 2252, for example, ReRAM (resistive RAM), PRAM (phase change RAM), or MRAM (magnetic RAM), or may include a magnetic storage medium or an optical storage medium, etc.

DRAM (Dynamic RAM) 2253 may be used as buffer memory. For example, the DRAM 2253 may be DDR SDRAM (Double Data Rate Synchronous DRAM), LPDDR (Low Power DDR SDRAM), GDDR (Graphics DDR SDRAM), RDRAM (Rambus DRAM), or HBM (High Bandwidth Memory). However, the present disclosure is not limited thereto, and the storage device 2250 may use volatile memory or non-volatile memory other than DRAM as a buffer memory. DRAM 2253 may temporarily store (buffer) data to be written to the plurality of NAND flashes 2252 or data read from the plurality of NAND flashes 2252.

The storage server 2200 may further include a switch 2230 and a NIC 2240. The switch 2230 may selectively connect the processor 2210 and the storage device 2250 or selectively connect the NIC 2240 and the storage device 2250 under the control of the processor 2210. In some implementations, the processor 2210 and the NIC 2240 may be integrated into one. In some implementations, the storage device 2250 and the NIC 2240 may be integrated into one.

The storage devices 2150, 2150n, 2250, 2250m may correspond to the storage devices described above with reference to FIGS. 1 to 15. For example, the controller 2251 may transmit commands/addresses to the plurality of NAND flashes 2252 in response to a request provided from one of the processors 2110, 2110n, 2210, 2210m. The controller 2251 may transmit commands/addresses through pins that are different from the pins that transmit data. The controller 2251 may control data input/output operations of the plurality of NAND flashes 2252 by providing data output packets, data input packets, as well as select chip enable commands, select chip terminate commands, etc. through pins different from the pins that transmit data. The controller 2251 may improve the efficiency of data input/output operations through sequences for data output packets, select chip enable commands, select chip terminate commands, etc.

Each of the plurality of NAND flashes 2252 may be implemented as a non-volatile memory device as described above with reference to FIGS. 1 to 15. For example, each of the plurality of NAND flashes 2252 may receive commands/addresses through pins that are different from the pins that receive data. Each of the plurality of flash memories 1221 to 122m may perform data input/output operations along with efficient preloading operations and loading operations based on data output packets, data input packets, as well as select chip enable commands, select chip terminate commands, etc. According to some implementations, each of the plurality of NAND flashes 2252 may reduce the overall processing time for a write request of a plurality of random read patterns without data collision through simultaneous operation of a data output operation and a preloading operation.

Embodiments are set out in the following Clauses:
Clause 1. A storage device comprising:
   a non-volatile memory device including
      a memory interface circuit including a data pin configured to output a data signal and a command address pin separated from the data pin and configured to receive a first data output packet and a second data output packet,
      a first page buffer configured to output first data in response to the first data output packet, and
      a second page buffer configured to output second data in response to the second data output packet; and
   a storage controller configured to provide the first data output packet and a first select chip enable command corresponding to the first data output packet to the non-volatile memory device through the command address pin, and provide the second data output packet between the first select chip enable command and a select chip terminate command corresponding to the first select chip enable command.
Clause 2. The storage device of Clause 1, wherein:
   the non-volatile memory device is configured to perform a first data input/output operation for the first data output packet through the data pin in response to the first select chip enable command,
   wherein the storage controller is configured to provide the second data output packet through the command address pin during the first data input/output operation.
Clause 3. The storage device of Clause 1 or Clause 2, wherein:
   the non-volatile memory device includes a first register configured to provide the first data to a first path based on a first clock signal generated based on a toggle signal received from the storage controller and provide the first data to a second path different from the first path based on a second clock signal different from the first clock signal.
Clause 4. The storage device of any of Clauses 1-3, comprising:
   a first register configured to provide the first data to the memory interface circuit based on a first clock signal, and a second register configured to provide the second data to the memory interface circuit based on a second clock signal,
   wherein the memory interface circuit includes
      a first pin configured to receive a toggle signal received from the storage controller, and
      a demultiplexer configured to provide the second clock signal to the first register, and provide the second clock signal to the second register.
Clause 5. The storage device of Clause 4, wherein
   the non-volatile memory device comprises:
   a divider configured to divide the toggle signal to generate a third clock signal,
   an internal clock generator configured to generate a fourth clock signal different from the first clock signal in response to reception of the first data output packet, and
   a multiplexer configured to receive the third clock signal and the fourth clock signal and provide at least one of the third clock signal or the fourth clock signal to the demultiplexer.
Clause 6. The storage device of any of Clauses 1-3, comprising:
   a first register configured to provide the first data to the memory interface circuit based on a clock signal, and a second register configured to provide the second data to the memory interface circuit based on a clock signal,
   wherein the memory interface circuit includes
      a first pin configured to receive a toggle signal received from the storage controller, and
   a demultiplexer configured to provide a first portion of a first clock signal generated based on the toggle signal to the first register, and provide a second portion of the first clock signal to the second register.
Clause 7. The storage device of Clause 5, wherein
   the non-volatile memory device comprises:
   a divider configured to divide the toggle signal to generate the first clock signal,
   an internal clock generator configured to generate a second clock signal different from the first clock signal in response to reception of the first data output packet, and
   a multiplexer configured to receive the first clock signal and the second clock signal and provide one of the first clock signal and the second clock signal to the demultiplexer.
Clause 8. The storage device of any of Clauses 1-3, comprising:
   a first register configured to provide the first data to the memory interface circuit based on a first portion of a first clock signal, and a second register configured to provide the second data to the memory interface circuit based on a second portion of the first clock signal,
   wherein the memory interface circuit includes
   a first pin configured to receive a toggle signal received from the storage controller, and
   a demultiplexer configured to provide the first portion of the first clock signal to the first register and provide the second portion of the first clock signal to the second register, wherein the first portion of the first clock signal is generated based on the toggle signal.
Clause 9. The storage device of Clause 8, wherein
   the non-volatile memory device comprises:
   a divider configured to divide the toggle signal to generate a second clock signal,
   an internal clock generator configured to generate a third clock signal different from the second clock signal in response to reception of the first data output packet, and
   a multiplexer configured to receive the second clock signal and the third clock signal and provide one of the second clock signal and the third clock signal to the demultiplexer.
Clause 10. The storage device of Clause 10 wherein the demultiplexer is configured to provide the second clock signal to the first register as the first portion of the first clock signal and to provide the third clock signal to the second register as the second portion of the first clock signal.
Clause 11. A non-volatile memory device comprising:
   a data pin configured to input data and output data;
   a command address pin, separated from the data pin and configured to receive a first data output packet and a second data output packet in sequence;
   a first pin configured to receive a first toggle signal corresponding to the first data output packet and a second toggle signal corresponding to the second data output packet;
   a first page buffer configured to output first data in response to the first data output packet;
   a second page buffer configured to output second data in response to the second data output packet;
   a first register configured to receive the first data and output the first data based on a first clock signal;
   a second register configured to receive the second data and provide the first data to the data pin based on a second clock signal; and
   a demultiplexer configured to provide the second clock signal to a clock processing circuit which is configured to provide the first clock signal to the first register, wherein the first clock signal is based on the second clock signal, and provide the second clock signal to the second register.
Clause 12. A non-volatile memory device comprising:
   a data pin configured to input data and output data;
   a command address pin, separated from the data pin and configured to receive a first data output packet and a second data output packet in sequence;
   a first pin configured to receive a first toggle signal corresponding to the first data output packet and a second toggle signal corresponding to the second data output packet;
   a first page buffer configured to output first data in response to the first data output packet;
   a second page buffer configured to output second data in response to the second data output packet;
   a first register configured to receive the first data and output the first data based on a clock signal;
   a second register configured to receive the second data and provide the first data to the data pin based on a clock signal; and
   a demultiplexer configured to provide a first portion of a first clock signal generated based on the first toggle signal to the first register and provide a second portion of the first clock signal to the second register.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A non-volatile memory device comprising:
a memory interface circuit (110) including
a data pin (P17) configured to output a data signal (DQ),
a command address pin (P1, P2) separated from the data pin (P17) and configured to receive a first data output packet (DOUT1), and
a first pin (P15) configured to receive a toggle signal (nRE) corresponding to the first data output packet (DOUT1);
a first page buffer (PB1) configured to output first data (D1) in response to the first data output packet (DOUT); and
a first register (142_1) configured to provide the first data (D1) to the memory interface circuit (110) through a first path in response to receiving a first clock signal (CLKb) generated based on the toggle signal (nRE), wherein the first register (142_1) is configured to provide the first data (D1) to the memory interface circuit (110) through a second path different from the first path in response to receiving a second clock signal (CLK_a) different from the first clock signal (CLK_b).

2. The non-volatile memory device of claim 1, comprising:
a first memory cell array (130_1) connected to the first page buffer (PB1) and including a plurality of first memory cells;
a second memory cell array (130_2) separated from the first memory cell array (130_1) and including a plurality of second memory cells (130_2);
a second page buffer (PB2) connected to the second memory cell array (130_2) and configured to output second data (D2) in response to a second data output packet (DOUT2) different from the first data output packet (DOUT1); and
a second register (142_2) configured to provide the second data (D2) to the memory interface circuit (110) through the first path in response to receiving the first clock signal (CLKb), and provide the second data to the memory interface circuit (110) through the second path in response to receiving the second clock signal (CLKa).

3. The non-volatile memory device of claim 2, wherein the second register is configured to:
in at least a portion of a period in which the memory interface circuit (110) is configured to output a data signal (DQ) for the first data (D1) through the data pin (P17), provide the second data (D2) to the memory interface circuit (110) through the second path; and/or
in at least a portion of a period in which the first register (142_1) is configured to receive the first clock signal (CLKb), receive the second clock signal (CLKa).

4. The non-volatile memory device of any of claim 2 or claim 3, wherein:
the memory interface circuit (110) is configured to receive the second data output packet (DOUT2) via the command address pin (P1, P2) while outputting a data signal (DQ) for the first data (D1) via the data pin (P17).

5. The non-volatile memory device of any preceding claim, comprising:
a clock processing circuit (141_1) configured to receive and preprocess the first clock signal (CLKb) and the second clock signal (CLKa), and provide at least one of the first clock signal (CLKb) or the second clock signal (CLKa) to the first register (142_1).

6. The non-volatile memory device of any preceding claim, wherein:
the first data (D1) includes first partial data (D1b) and second partial data (D1a),
wherein the first register (142_1) is configured to provide the first partial data (D1b) to the memory interface circuit (110) through the first path and provide the second partial data (D1a) to the memory interface circuit (110) through the second path.

7. The non-volatile memory device of claim 6, wherein:
the first register (142_1) is configured to provide the first data (D1) to the memory interface circuit (110) in an order of the second partial data (D1a) and the first partial data (D1b).

8. The non-volatile memory device of claim 6 or claim 7, wherein:
the memory interface circuit (110) includes an output register (1104) configured to receive the second partial data (D1a) through the second path and provide the second partial data (D1a) to the data pin (P17).

9. The non-volatile memory device of claim 8, wherein:
the memory interface circuit (110) includes a synchronizer (1105) configured to receive the first partial data (D1b) from the first register (142_1), receive the second partial data (D1a) from the output register (1104), and control an output timing of the second partial data (D1a) to sequentially provide the second partial data (D1a) and the first partial data (D1b) to the data pin (P17).

10. The non-volatile memory device of claim 8 or claim 9, wherein:
the output register (1104) is configured to provide the second partial data (D1a) to the data pin (P17) based on the first clock signal (CLKb).

11. The non-volatile memory device of any preceding claim, comprising:
a divider (1102) configured to divide the toggle signal (nRE) to generate the first clock signal (CLKb); and
an internal clock generator (1103, 121) configured to generate the second clock signal (CLKa) in response to receiving the first data output packet (DOUT1).

12. A method of operating a storage device comprising:
providing a first data output packet to a first page buffer of a first plane through a command address pin of a non-volatile memory device (S110);
preloading the first page buffer based on the first data output packet (S120);
providing a first select chip enable command corresponding to the first data output packet to the non-volatile memory device through the command address pin (S130);
outputting first data stored in the first page buffer through a data pin different from the command address pin, based on the first select chip enable command (S140); and
providing, during the outputting of the first data, a second data output packet to a second page buffer of a second plane different from the first plane to the non-volatile memory device through the command address pin (S150).

13. The method of operating a storage device of claim 12, comprising:
preloading, during the outputting of the first data, the second page buffer based on the second data output packet (S160).

14. The method of operating a storage device of claim 12 or claim 13, comprising:
after providing the second data output packet, providing a select chip terminate command corresponding to the first select chip enable command to the non-volatile memory device through the command address pin (S170).

15. A non-volatile memory device comprising:
a data pin (P17) configured to input data and output data;
a command address pin (P1, P2), separated from the data pin (P17) and configured to receive a first data output packet (DOUT3) and a second data output packet (DOUT4) in sequence;
a first pin (P15) configured to receive a first toggle signal (nRE3) corresponding to the first data output packet (DOUT3) and a second toggle signal (nRE4) corresponding to the second data output packet (DOUT4);
a first page buffer (PB1) configured to output first data (D1) in response to the first data output packet (DOUT3);
a second page buffer (PB2) configured to output second data (D2) in response to the second data output packet (DOUT4);
a first register (142_1') configured to receive the first data (D1) and output the first data (D1) based on a first portion of a first clock signal (CLK);
a second register (142_2') configured to receive the second data (D2) and provide the first data (D1) to the data pin (P17) based on a second portion of a first clock signal (CLK); and
a demultiplexer (1125) configured to provide the first portion of the first clock signal (CLK) generated based on the first toggle signal (nRE3) to the first register (142_1') and provide the second portion of the first clock signal (CLK) to the second register (142_2').
